(19) Europäisches Patentamt
European Patent Office
Office européen des brevets

(11) EP 2 757 394 B1

(12) # EUROPEAN PATENT SPECIFICATION

(45) Date of publication and mention of the grant of the patent:
**10.05.2017 Bulletin 2017/19**

(21) Application number: **12832087.6**

(22) Date of filing: **13.09.2012**

(51) Int Cl.:
***G02B 5/30*** (2006.01)
***C08G 64/16*** (2006.01)
***C08J 5/18*** (2006.01)
***G02F 1/1335*** (2006.01)
***G02F 1/13363*** (2006.01)
***H01L 51/50*** (2006.01)
***H05B 33/02*** (2006.01)

(86) International application number:
**PCT/JP2012/073528**

(87) International publication number:
**WO 2013/039179 (21.03.2013 Gazette 2013/12)**

(54) **PHASE DIFFERENCE FILM, CIRCULARLY POLARIZING PLATE USING SAME, AND IMAGE DISPLAY DEVICE**

PHASENDIFFERENZFILM, ZIRKULÄRE POLARISIERENDE PLATTE DAMIT UND BILDANZEIGEVORRICHTUNG

FILM À DIFFÉRENCE DE PHASE, PLAQUE DE POLARISATION CIRCULAIRE L’UTILISANT, ET DISPOSITIF D’AFFICHAGE D’IMAGES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.09.2011 JP 2011200766**
**01.08.2012 JP 2012171499**

(43) Date of publication of application:
**23.07.2014 Bulletin 2014/30**

(73) Proprietors:
- **Mitsubishi Chemical Corporation**
**Chiyoda-ku**
**Tokyo 100-8251 (JP)**
- **Nitto Denko Corporation**
**Ibaraki-shi, Osaka 567-8680 (JP)**

(72) Inventors:
- **TANAKA Tomohiko**
**Kitakyushu-shi, Fukuoka 806-0004 (JP)**
- **YOKOGI Masashi**
**Kitakyushu-shi, Fukuoka 806-0004 (JP)**
- **MURAKAMI Nao**
**Ibaraki-shi, Osaka 567-8680 (JP)**
- **IIDA Toshiyuki**
**Ibaraki-shi, Osaka 567-8680 (JP)**

(74) Representative: **Vossius & Partner**
**Patentanwälte Rechtsanwälte mbB**
**Siebertstrasse 3**
**81675 München (DE)**

(56) References cited:
**EP-A1- 2 708 568**
**WO-A1-2011/062163**
**JP-A- 2010 134 232**
**JP-A- 2010 134 232**
**JP-A- 2010 191 385**
**JP-A- 2011 150 325**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 757 394 B1

## Description

### Technical Field

The present invention relates to a retardation film insusceptible to color dropout or color shift even under environment of severe temperature or humidity conditions and capable of being produced by a melt film-forming method, and a circularly polarizing plate and an image display device each using the retardation film.

### Background Art

A retardation film exhibiting the reverse wavelength dispersion property of decreasing in phase retardation at a shorter wavelength makes it possible to obtain ideal phase retardation properties at each wavelength in the visible region and is useful as a so-called circularly polarizing plate for preventing external light reflection of an image display device. As the retardation film having such a performance, a retardation film composed of a polycarbonate resin using, as a raw material, 9,9-bis[4-(2-hydroxyethoxy)phenyl]fluorene or 9,9-bis(4-hydroxy-3-methylphenyl)fluorene is disclosed (see, for example, Patent Document 1).

However, the polycarbonate resin described in Patent Document 1 can be hardly film-formed by a melt film-forming method because of its high glass transition temperature, and the original film (a film before stretching treatment) is produced by a solution casting method. In the solution casting method, literally, a solvent must be used and therefore, there is a problem that not only the environment impact is high and improvement is required but also the solvent remaining in the product retardation film plastically acts and causes a change in optical properties due to an external environmental change such as temperature and humidity and in turn, color dropout or color shift is produced. In addition, as the solvent used for the solution casting, a chlorine-based solvent such as dichloromethane is often used in view of solubility, volatility and incombustibility, and this solvent has a problem of incurring corrosion of the equipment during processing into a retardation film or adversely affecting other parts when incorporated into an image display device. Furthermore, the original film obtained from the polycarbonate resin disclosed in Patent Document 1 is very brittle and therefore, has a problem that the processability is poor, for example, the film is ruptured during stretching.

As the film using a resin capable of producing a original film by melt film formation, a film composed of a ternary copolymer polycarbonate resin using, as raw materials, isosorbide, biscresolfluorene and an aliphatic diol, an alicyclic diol, a spiroglycol or the like is disclosed (see, Patent Document 2).

Also, a film composed of a binary copolymer polycarbonate resin of 9,9-bis[4-(2-hydroxyethoxy)phenyl]fluorene or 9,9-bis(4-hydroxy-3-methylphenyl)fluorene and an alicyclic diol having a carbon number of 4 to 20 or a heteroatom-containing cyclic dihydroxy compound is disclosed (see, Patent Document 3).

However, the polycarbonate resins disclosed in Patent Documents 2 and 3 have not succeeded in overcoming the difficulty of original film formation due to brittleness of the film based on the molecular structure or the difficulty of withstanding subsequent stretching, and these resins are also not satisfactory with respect to deterioration or unevenness of image quality of the retardation film or change in the wavelength dispersion property in a long-term use or under severe usage environment.

### Background Art Document

#### Patent Document

Patent Document 1: Japanese Patent No. 3325560
Patent Document 2: International Publication No. 2006/41190
Patent Document 3: International Publication No. 2010/64721

### Summary of Invention

#### Problem that Invention is to Solve

In this way, it is strongly demanded that the original film for a retardation film having a reverse wavelength dispersion property used in various image display devices, mobile devices and the like showing rapid growth in recent years is formed by a melt film-forming method using no solvent so as to improve phase retardation distribution or thickness unevenness or reduce the environmental impact. Furthermore, the retardation film used in such a field is sometimes utilized, unlike normal usage, in various temperature or humidity conditions and therefore, is required to cause little

change in its optical properties even when the usage environment is changed, particularly, be prevented from image quality deterioration such as color dropout or color shift of an image in a long-term use. Among others, in an organic EL display recently receiving attention as a next-generation image display device, a reflection layer inside the display is indispensable in principle and in turn, more enhancement of the external light reflection-preventing performance and stabilization of the optical properties less susceptible to a harsh environmental change have been strongly demanded.

An object of the present invention is to provide a retardation film succeeded in solving those conventional problems, that is, a retardation film insusceptible to color dropout or color shift even under environment of severe temperature or humidity conditions and capable of being produced by a melt film-forming method. Another object of the present invention is to provide a circularly polarizing plate and an image display device each using such a retardation film.

Means for Solving Problem

As a result of many studies to solve those problems, the present invention has found that the above-described object can be attained by a retardation film having a retardation ratio satisfying a specific relational expression. The present invention has been accomplished based on this finding.

That is, the gist of the present invention resides in the following [1] to [13].

[1] A retardation film satisfying the relationships of the following formulae (A) and (B):

$$\text{Formula (A): } 0.7 < R_1(450)/R_1(550) < 1$$

$$\text{Formula (B): } |R_2(450)/R_2(550) - R_1(450)/R_1(550)| < 0.020$$

(wherein $R_1(450)$ and $R_1(550)$ represent the retardation value in film plane at respective wavelengths of 450 nm and 550 nm, and $R_2(450)$ and $R_2(550)$ represent the retardation value in film plane at respective wavelengths of 450 nm and 550 nm after leaving the film to stand at a temperature of 90°C for 48 hours), and further satisfying the relationships of the following formulae (C) and (D):

$$\text{Formula (C): } 1 < R_1(650)/R_1(550) < 1.2$$

$$\text{Formula (D): } |R_2(650)/R_2(550) - R_1(650)/R_1(550)| < 0.010$$

(wherein $R_1(650)$ represents the retardation value in film plane at a wavelength of 650 nm, and $R_2(650)$ represents the retardation value in film plane at a wavelength of 650 nm after leaving the film to stand at a temperature of 90°C for 48 hours), which is a retardation film obtained by forming a polymer containing (a) a structural unit having a positive refractive index anisotropy with the absorption end being less than 260 nm and (b) a structural unit having a negative refractive index anisotropy with the absorption end being from 260 to 380 nm,

wherein:

said polymer is a polycarbonate resin,
said structural unit (b) is a structural unit derived from a dihydroxy compound represented by the following formula (1), and
said structural unit (a) is a structural unit derived from a dihydroxy compound represented by the following formula (2) and structural units derived from one or more dihydroxy compounds selected from the group consisting of a dihydroxy compound represented by the following formula (3), a dihydroxy compound represented by the following formula (4), a dihydroxy compound represented by the following formula (5) and a dihydroxy compound represented by the following formula (6):

[Chem. 1]

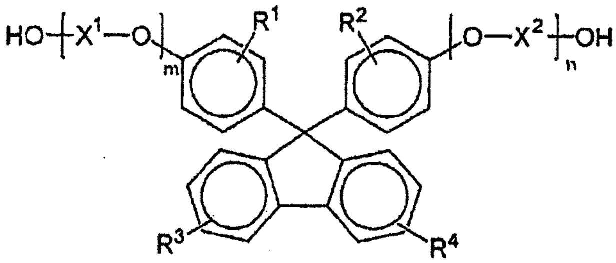

(1)

(wherein each of $R^1$ to $R^4$ independently represents a hydrogen atom, a substituted or unsubstituted alkyl group having a carbon number of 1 to 20, a substituted or unsubstituted cycloalkyl group having a carbon number of 6 to 20, or a substituted or unsubstituted aryl group having a carbon number of 6 to 20, and the same or different groups are substituted as respective substituents on four benzene rings; each of $X^1$ and $X^2$ independently represents a substituted or unsubstituted alkylene group having a carbon number of 2 to 10, a substituted or unsubstituted cycloalkylene group having a carbon number of 6 to 20, or a substituted or unsubstituted arylene group having a carbon number of 6 to 20; and each of m and n independently represents an integer of 0 to 5);

[Chem. 2]

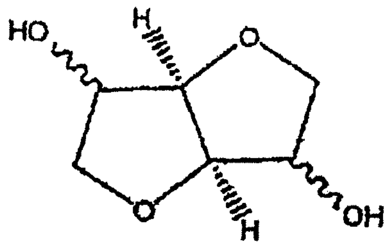

(2)

$HO-R^5-OH$ (3)

(wherein $R^5$ represents a substituted or unsubstituted cycloalkylene group having a carbon number of 4 to 20);

$HO-CH_2-R^6-CH_2-OH$ (4)

(wherein $R^6$ represents a substituted or unsubstituted cycloalkylene group having a carbon number of 4 to 20);

$H-(O-R^7)_p-OH$ (5)

(wherein $R^7$ represents a substituted or unsubstituted alkylene group having a carbon number of 2 to 10, and p represents an integer of 2 to 50); and

$HO-R^8-OH$ (6)

(wherein $R^8$ represents a substituted or unsubstituted alkylene group having a carbon number of 2 to 20, or a group represented by the following formula (6A)):

[Chem. 3]

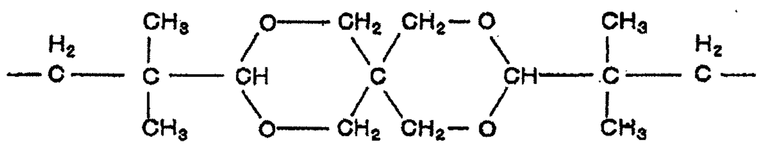

(6A)

[6] The retardation film as described in the above [5], wherein in said polymer, the content of the structural unit derived from a dihydroxy compound having an acetal structure is 10 mol% or less based on all dihydroxy compound-derived structural units.

[7] The retardation film as described in the above [5] or [6], wherein:

said structural unit (b) is a structural unit derived from said dihydroxy compound represented by formula (1), and said structural unit (a) is a structural unit derived from said dihydroxy compound represented by formula (2) and a structural unit derived from said dihydroxy compound represented by formula (5).

[8] The retardation film as described in any one of the above [1] to [7], which is a single-layer film.

[9] The retardation film as described in any one of the above [3] to [8], wherein the photoelastic coefficient of said polymer is $45\times10^{-12}$ $Pa^{-1}$ or less.

[10] The retardation film as described in any one of the above [1] to [9], wherein the glass transition temperature is from 110 to 150°C.

[11] A circularly polarizing plate fabricated by stacking the retardation film claimed in any one of the above [1] to [10] and a polarizing plate.

[12] An image display device having the circularly polarizing plate claimed in the above [11].

[13] The image display device as described in the above [12], wherein said image display device uses an organic EL.

Advantageous Effect of the Invention

Since the retardation film of the present invention exerts a low environmental impact, can be formed by a melt film-forming method excellent in profitability, is insusceptible to color dropout or color shift even in a long-term usage under the high temperature/high humidity conditions, and is subject to little deterioration of the image quality, the retardation film of the present invention and a circularly polarizing plate and an image display device each using the retardation film can be suitably used, for example, as an optical compensation film of a display for in-vehicle equipment or as a 1/4 λ plate for a circularly polarizing plate to prevent reflection of an organic EL.

Mode for Carrying Out Invention

[Retardation Film]

The retardation film of the present invention is formed of at least one polymer selected from the later-described polycarbonate and polyester carbonate, satisfies the relationships of the following formulae (A) and (B), and preferably further satisfies the relationships of the following formulae (C) and (D), and the retardation film as a single-layer film (one sheet of film) preferably satisfies the relationships of the following formulae (A) and (B), more preferably further satisfies the relationships of the following formulae (C) and (D). A retardation film composed of a laminate film is increased in the thickness and therefore, the retardation film of the present invention preferably composed of a single-layer film.

$$\text{Formula (A): } 0.7<R_1(450)/R_1(550)<1$$

$$\text{Formula (B): } |R_2(450)/R_2(550)-R_1(450)/R_1(550)|<0.020$$

(wherein $R_1(450)$ and $R_1(550)$ represent the retardation value in film plane at respective wavelengths of 450 nm and

550 nm, and $R_2(450)$ and $R_2(550)$ represent the retardation value in film plane at respective wavelengths of 450 nm and 550 nm after leaving the film to stand at a temperature of 90°C for 48 hours).

$$\text{Formula (C): } 1<R_1(650)/R_1(550)<1.2$$

$$\text{Formula (D): } |R_2(650)/R_2(550)-R_1(650)/R_1(550)|<0.010$$

(wherein $R_1(650)$ represents the retardation value in film plane at a wavelength of 650 nm, and $R_2(650)$ represents the retardation value in film plane at a wavelength of 650 nm after leaving the film to stand at a temperature of 90°C for 48 hours).

In the retardation film of the present invention, the retardation value in film plane at a measurement wavelength of 550 nm is usually from 100 to 180 nm, preferably from 120 to 170 nm, more preferably from 135 to 155 nm, and the retardation value is measured by the method described in the paragraph of Examples later.

[Re: Formulae (A) to (D)]

<Formula (A)>

The retardation film of the present invention satisfies the relationship of formula (A) and characterized in that $R_1(450)/R_1(550)$ is from more than 0.7 to less than 1.

In the retardation film of the present invention, $R_1(450)/R_1(550)$ is preferably from 0.70 to 0.99, more preferably from 0.75 to 0.97, still more preferably from 0.75 to 0.95, yet still more preferably from 0.86 to 0.93, and most preferably from 0.88 to 0.91.

When the value of $R_1(450)/R_1(550)$ is in the range above, a higher phase retardation develops at a longer wavelength, and ideal phase retardation properties can be obtained at each wavelength in the visible region. For example, the retardation film of the present invention having such a wavelength dependency is laminated as a 1/4λ plate to a polarizing plate, whereby a circularly polarizing plate and the like can be produced, and a circularly polarizing plate and an image display device each exhibiting excellent blackness by having a function of preventing external light reflection at all wavelengths can be realized. On the other hand, if the value of $R_1(450)/R_1(550)$ is outside the range above, color dropout due to wavelength is increased, and there arises a problem of coloration in the circularly polarizing plate or image display device.

<Formula (B)>

The retardation film of the present invention satisfies the relationship of formula (B) and is characterized in that $|R_2(450)/R_2(550)-R_1(450)/R_1(550)|$ (that is, the absolute value of difference between $R_2(450)/R_2(550)$ and $R_1(450)/R_1(550)$) is less than 0.020.

In the retardation film of the present invention, $|R_2(450)/R_2(550)-R_1(450)/R_1(550)|$ is preferably from more than 0 to not more than 0.018, more preferably from more than 0 to not more than 0.015, still more preferably from more than 0 to not more than 0.010.

A retardation film where $|R_2(450)/R_2(550)-R_1(450)/R_1(550)|$ is less than 0.020 shows little variation in the phase retardation even in a long-term use under the high temperature condition and advantageously exhibits excellent stability against temperature. Also, this value is preferably closer to 0, because the difference from the initially designed value decreases.

<Formula (C)>

The retardation film of the present invention satisfies the relationship of formula (C), and $R_1(650)/R_1(550)$ is preferably from more than 1 to less than 1.2.

In the retardation film of the present invention, $R_1(650)/R_1(550)$ is preferably from more than 1.00 to less than 1.20, more preferably from more than 1.00 to 1.10 or less, still more preferably from more than 1.00 to 1.05 or less, yet still more preferably from more than 1.00 to 1.035 or less.

When the value of $R_1(650)/R_1(550)$ is in the range above, a higher phase retardation is produced at a longer wavelength, and further ideal phase retardation properties can be obtained at each wavelength in the visible region. For example, the retardation film of the present invention having such a wavelength dependency is laminated as a 1/4λ plate

to a polarizing plate, whereby a circularly polarizing plate and the like can be produced, and a circularly polarizing plate and an image display device each exhibiting excellent blackness by having a function of preventing external light reflection at all wavelengths can be realized. On the other hand, even when the retardation film satisfies the relationship of formula (A), if the value of $R_1(650)/R_1(550)$ is outside the range above, color dropout and the like may occur.

<Formula (D)>

The retardation film of the present invention satisfies the relationship of formula (D), and $|R_2(650)/R_2(550)-R_1(650)/R_1(550)|$ (that is, the absolute value of difference between $R_2(650)/R_2(550)$ and $R_1(650)/R_1(550)$) is preferably less than 0.010, more preferably 0.008 or less, still more preferably 0.0075 or less.

A retardation film where $|R_2(650)/R_2(550)-R_1(650)/R_1(550)|$ is in the range above shows less variation in phase retardation even in a long-term use under the high temperature condition and advantageously exhibits more excellent stability against temperature. This value is preferably closer to 0.

The retardation film of the present invention is characterized in that the original film thereof can be produced by melt film formation and the change in its optical properties is little involved even when the usage environment is changed, and in order to achieve both of these properties, control of the glass transition temperature of the polymer constituting the retardation film is important.

The lower limit of the glass transition temperature of the polymer for use in the retardation film of the present invention is preferably 110°C or more, more preferably 120°C or more, still more preferably 125°C or more, yet still more preferably 130°C or more, and most preferably 140°C or more. If the glass transition temperature is excessively low, the heat resistance tends to be poor, and a change may occur in the optical properties at a high temperature or a high humidity. On the other hand, the upper limit is preferably 180°C or less, more preferably 160°C or less, still more preferably 150°C or less. If the glass transition temperature is excessively high, the film-forming temperature of original film or the temperature during stretching must be raised, and the polymer may undergo molecular weight reduction, coloration or the like or a film defect may be incurred due to gas evolution. Furthermore, a film having a uniform thickness is difficult to obtain, and a phase retardation may develop unevenly.

The method for measuring the glass transition temperature of the present invention is described in the paragraph of Examples.

[Other Physical Properties]

<Thickness>

The thickness of the optical film of the present invention is, usually, preferably 150 μm or less, more preferably 100 μm or less, still more preferably 60 μm or less. If the thickness of the retardation film is excessively thick, a larger amount of film-forming material is inefficiently required to produce a film having the same area, or the thickness of a product using the film may become large, and at the same time, the uniformity can be hardly controlled, giving a film inapplicable to a device requiring precision, thinness and homogeneity. The lower limit of the thickness of the retardation film of the present invention is preferably 5 μm or more, more preferably 10 μm or more. If the thickness of the retardation film is too thin, the film may be difficult to handle, and a wrinkle may be generated during production or lamination to, for example, another film or sheet such as protective film may be disturbed.

<Internal Haze>

In the retardation film of the present invention, the internal haze is preferably 3% or less, more preferably 1.5% or less. If the internal haze of the retardation film exceeds the upper limit above, scattering of light occurs and, for example, when stacked on a polarizer, the light scattering gives rise to depolarization. The lower limit of the internal haze is not particularly specified but is usually 0.2% or more.

Incidentally, the internal haze of an optical film is measured at 23°C by using, for example, a haze meter ("HM-150" manufactured by Murakami Color Research Laboratory Co., Ltd.). The measurement sample used is a film from which the effect of external haze is removed by laminating a pressure-sensitive adhesive-attached transparent film whose haze is previously measured, to both surfaces of a sample film, and the difference from the haze value of the pressure-sensitive adhesive-attached transparent film is used as the measured value.

<b* Value>

In the retardation film of the present invention, the b* value is preferably 3 or less. If the b* value of the retardation film is too large, there arises a problem such as coloration. The b* value of the retardation film of the present invention

is more preferably 2 or less, still more preferably 1 or less.

Incidentally, the b* value of the retardation film is measured, for example, at 23°C with light having a wavelength of 550 nm by using a spectrophotometer ("DOT-3", manufactured by Murakami Color Research Laboratory Co., Ltd.).

<Total Light Transmittance>

In the retardation film of the present invention, irrespective of thickness, the total light transmittance of the retardation film itself is preferably 80% or more. This transmittance is more preferably 90% or more. When the transmittance does not fall below this lower limit, a retardation film resistant to coloration is obtained and its lamination with a polarizing plate gives a circularly polarizing plate having a high polarization degree or a high transmittance, making it possible to realize high display quality in use for an image display device. Incidentally, the upper limit of the total light transmittance of the retardation film of the present invention is not particularly limited but is usually 99% or less.

<Refractive Index>

In the retardation film of the present invention, the refractive index at sodium d line (589 nm) is preferably from 1.57 to 1.62. If this refractive index is less than 1.57, the birefringence may be too small, whereas if the refractive index exceeds 1.62, the reflectance may be increased to deteriorate the light transmitting property.

<Birefringence>

In the retardation film of the present invention, the birefringence is preferably 0.001 or more. In order to design the film molded using the later-described resin composition of the present invention to have a very small thickness, the birefringence is preferably higher. Therefore, the birefringence is more preferably 0.0015 or more and most preferably 0.002 or more. If the birefringence is less than 0.001, the thickness of the film must be made excessively large and in turn, the amount of the film-forming material used is increased, making it difficult to control the homogeneity in terms of thickness, transparency and phase retardation. As a result, in the case where the birefringence is less than 0.001, the film may be inapplicable to a device requiring precision, thinness and homogeneity.

The upper limit of the birefringence is not particularly limited, but if the stretching temperature is excessively lowered or the stretching ratio is excessively increased so as to attain a large birefringence, rupture during stretching or non-uniformity of the stretch film may be caused, and therefore, the birefringence is usually 0.007 or less.

<Water Absorption Percentage>

In the retardation film of the present invention, the saturated water absorption percentage is preferably more than 1.0 wt%. When the water absorption percentage is more than 1.0 wt%, at the time of laminating this retardation film to another film or the like, the adhesiveness can be easily ensured. For example, in the case of laminating the retardation film to a polarizing plate, the adhesive can be freely designed because the retardation film is hydrophilic and has a small contact angle with water, and a high degree of adhesion design can be made. If the water absorption percentage is 1.0 wt% or less, the film is hydrophobic and has a large contact angle with water, making it difficult to design the adhesiveness. In addition, the film is likely to be electrostatically charged, and there arises a problem that when this film is incorporated into a circularly polarizing plate or an image display device, the number of appearance defects increases due to, for example, inclusion of a foreign matter. On the other hand, if the water absorption percentage exceeds 2.0 wt%, the durability of optical properties in a humid environment becomes poor, and this is not preferred. In the retardation film of the present invention, the water absorption percentage is preferably from more than 1.0 wt% to not more than 2.0 wt%, more preferably from 1.1 wt% to 1.5 % wt%.

[Production Method of Retardation Film]

The method for producing the retardation film of the present invention satisfying the above-described conditions is not particularly limited and may be sufficient if it is a method capable of producing a retardation film satisfying those conditions, but, for example, an original film is obtained by a melt film-forming method and at the time of stretching, if desired, the original film to produce a retardation film, one technique or two or more techniques of the following (i) to (iv) are employed, whereby the retardation film of the present invention can be produced.

(i) The copolymerization compositional ratio of the polymer used as the film-forming material of the retardation film is controlled.

(ii) A resin composition containing a reactive functional group-containing compound is used as the film-forming

material of the retardation film.
(iii) The conditions in the stretching step are controlled.
(iv) Crosslinking is formed after film formation and stretching.

The techniques of (i) to (iv) for realizing production of the retardation film are described below.

{(i) Method where the copolymerization compositional ratio of the polymer is controlled}

The method for producing the retardation film of the present invention by controlling the copolymerization composition ratio of the polymer used as the film-forming material is described below.
In order to produce the retardation film of the present invention satisfying the relationships of formulae (A) and (B), preferably further satisfying the relationships of formulae (C) and (D), the polymer used as the film-forming material of the retardation film of the present invention (hereinafter, sometimes referred to as "the polymer of the present invention") preferably contains (a) a structural unit having a positive refractive index anisotropy with the absorption end being less than 260 nm and (b) a structural unit having a negative refractive index anisotropy with the absorption end being from 260 to 380 nm.
Here, the absorption end was determined by producing a homopolymer of each structural unit and measuring a film obtained by hot press molding for the transmittance in steps of 2 nm from 190 nm to 500 nm by means of an ultraviolet-visible spectrophotometer "V-570" (manufactured by JASCO Corporation). As for the absorption end, when the transmittance is observed from the long wavelength side to the short wavelength side, the wavelength at which the transmittance becomes 0 or less is taken as the absorption end. The hot press molding was performed by sandwiching the homopolymer film between polyimide films through an aluminum-made spacer having a thickness of 100 μm. As for the thickness of the obtained film, the press temperature and the press pressure were appropriately set to give a thickness of 150 μm±30 μm.
Also, in the measurement of refractive index anisotropy, after producing a homopolymer of each structural unit and producing a film of the homopolymer under the same conditions as in the production above for the measurement of absorption end, the homopolymer film was 2-fold stretched by free-end uniaxial stretching under the condition of homopolymer glass transition temperature+20°C, and the refractive index of the resulting stretched film was measured by an Abbe refractometer "DR-4" (manufactured by ATAGO Co., Ltd.) and judged as "positive" when the refractive index in the stretching direction is higher than the refractive index in the direction orthogonal to the stretching direction, and as "negative" when the refractive index in the direction orthogonal to the stretching direction is higher than the refractive index in the stretching direction.
The polymer of the present invention may contain only one structural unit (a) or may contain two or more structural units (a). Also, as the structural unit (b), the polymer may contain only one structural unit or may contain two or more structural units.
The polymer of the present invention is not particularly limited but in view of heat resistance and ease of copolymerization, the polymer is preferably a polycarbonate resin and/or a polyester carbonate resin.
In the following, the structural unit and the like are described by referring, for example, to a case where the polymer of the present invention is a polycarbonate resin (hereinafter, sometimes referred to as "the polycarbonate resin of the present invention"), but the polymer of the present invention is not limited to a polycarbonate resin by any means.

<Structural Unit (a)>

The compound suitably used for the structural unit (a) of the polycarbonate resin of the present invention includes dihydroxy compounds represented by the following formulae (2) to (6):

[Chem. 4]

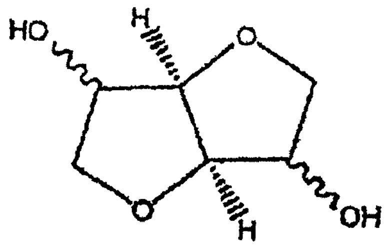

(2)

HO-$R^5$-OH (3)

(wherein $R^5$ represents a substituted or unsubstituted cycloalkylene group having a carbon number of 4 to 20);

HO-$CH_2$-$R^6$-$CH_2$-OH (4)

(wherein $R^6$ represents a substituted or unsubstituted cycloalkylene group having a carbon number of 4 to 20);

H-(O-$R^7$)$_p$-OH (5)

(wherein $R^7$ represents a substituted or unsubstituted alkylene group having a carbon number of 2 to 10, and p represents an integer of 2 to 50); and

HO-$R^8$-OH (6)

(wherein $R^8$ represents a substituted or unsubstituted alkylene group having a carbon number of 2 to 20, or a group represented by the following formula (6A)):

[Chem. 5]

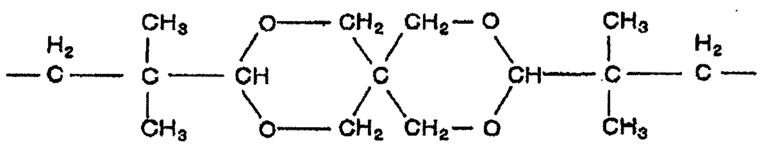

(6A)

Incidentally, in the description of the present invention, the carbon number of various groups, in the case where the group has a substituent, means the total carbon number including the carbon number of the substituent.

<Dihydroxy Compound Represented by Formula (2)>

The dihydroxy compound represented by formula (2) includes, for example, isosorbide, isomannide and isoidide, which are in a stereoisomeric relationship. One of these compounds may be used alone, or two or more thereof may be used in combination. Among these dihydroxy compounds, isosorbide obtained by dehydration condensation of sorbitol produced from various starches existing abundantly as a resource and being easily available is most preferred in view of availability, ease of production, optical properties and moldability.

<Dihydroxy Compound Represented by Formula (3)>

The dihydroxy compound represented by formula (3) is an alicyclic dihydroxy compound having on $R^5$ a substituted or unsubstituted cycloalkylene group with a carbon number of 4 to 20, preferably a carbon number of 4 to 18. Here, in the case where $R^5$ has a substituent, the substituent includes a substituted or unsubstituted alkyl group having a carbon number of 1 to 12, and in the case where this alkyl group has a substituent, the substituent includes, for example, an alkoxy group such as methoxy group, ethoxy group and propoxy group, and an aryl group such as phenyl group and naphthyl group.

This dihydroxy compound contains a ring structure, so that when the obtained polycarbonate resin is molded, toughness of the molded article can be enhanced, and among others, the toughness when molded into a film can be enhanced.

The cycloalkylene group of $R^5$ is not particularly limited as long as it is a hydrocarbon group containing a ring structure, and the structure may be a bridged structure having a bridgehead carbon atom. From the standpoint that production of the dihydroxy compound is easy and the amount of impurities can be reduced, the dihydroxy compound represented by formula (3) is preferably a compound containing a 5-membered ring structure or a 6-membered ring structure, that is, a dihydroxy compound where $R^5$ is a substituted or unsubstituted cyclopentylene group or a substituted or unsubstituted cyclohexylene group. Such a dihydroxy compound contains a 5-membered ring structure or a 6-membered ring structure, so that heat resistance of the obtained polycarbonate resin can be increased. The 6-membered ring structure may be fixed in a chair or boat form by covalent bonding.

Above all, in the dihydroxy compound represented by formula (3), $R^5$ is preferably a variety of isomers represented by the following formula (7). Here, in formula (7), $R^{11}$ represents a hydrogen atom or a substituted or unsubstituted alkyl group having a carbon number of 1 to 12. When $R^{11}$ is an alkyl group having a carbon number of 1 to 12 and having a substituent, the substituent includes, for example, an alkoxy group such as methoxy group, ethoxy group and propoxy group, and an aryl group such as phenyl group and naphthyl group.

[Chem. 6]

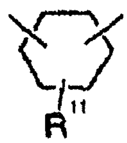

(7)

More specifically, examples of the dihydroxy compound represented by formula (3) include, but are not limited to, tetramethylcyclobutanediol, 1,2-cyclopentanediol, 1,3-cyclopentanediol, 1,2-cyclohexanediol, 1,3-cyclohexanediol, 1,4-cyclohexanediol, 2-methyl-1,4-cyclohexanediol, tricyclodecanediols, and pentacyclodiols.

One of these compounds may be used alone, or two or more thereof may be used in combination.

<Dihydroxy Compound Represented by Formula (4)>

The dihydroxy compound represented by formula (4) is an alicyclic dihydroxy compound having on $R^6$ a substituted or unsubstituted cycloalkylene group with a carbon number of 4 to 20, preferably a carbon number of 3 to 18. Here, in the case where $R^6$ has a substituent, the substituent includes a substituted or unsubstituted alkyl group having a carbon number of 1 to 12, and in the case where this alkyl group has a substituent, the substituent includes, for example, an alkoxy group such as methoxy group, ethoxy group and propoxy group, and an aryl group such as phenyl group and naphthyl group.

This dihydroxy compound contains a ring structure, so that when the obtained polycarbonate resin is molded, toughness of the molded article can be enhanced, and among others, toughness when molded into a film can be enhanced.

The cycloalkylene group of $R^6$ is not particularly limited as long as it is a hydrocarbon group containing a ring structure, and the structure may be a bridged structure having a bridgehead carbon atom. From the standpoint that production of the dihydroxy compound is easy and the amount of impurities can be reduced, the dihydroxy compound represented by formula (4) is preferably a compound containing a 5-membered ring structure or a 6-membered ring structure, that is, a dihydroxy compound where $R^6$ is a substituted or unsubstituted cyclopentylene group or a substituted or unsubstituted cyclohexylene group. Such a dihydroxy compound contains a 5-membered ring structure or a 6-membered ring structure, so that heat resistance of the obtained polycarbonate resin can be increased. The 6-membered ring structure may be fixed in a chair or boat form by covalent bonding. Above all, in the dihydroxy compound represented by formula (4), $R^6$ is preferably a variety of isomers represented by formula (7).

More specifically, examples of the dihydroxy compound represented by formula (4) include, but are not limited to, 1,2-cyclohexanedimethanol, 1,3-cyclohexanedimethanol, 1,4-cyclohexanedimethanol, 3,8-bis(hydroxymethyl)tricyclo[5.2.1.0$^{2.6}$]decane, 3,9-bis(hydroxymethyl)tricyclo[5.2.1.0$^{2.6}$]decane, 4,8-bis(hydroxymethyl)tricyclo[5.2.1.0$^{2.6}$]decane, 4,9-bis(hydroxymethyl)tricyclo[5.2.1.0$^{2.6}$]decane, 8-hydroxy-3-hydroxymethyltricyclo[5.2.1.0$^{2.6}$]decane, 9-hydroxy-3-hydroxymethyltricyclo[5.2.1.0$^{2.6}$]decane, 8-hydroxy-4-hydroxymethyltricyclo[5.2.1.0$^{2.6}$]decane, and 9-hydroxy-4-hydroxymethyltricyclo[5.2.1.0$^{2.6}$]decane.

One of these compounds may be used alone, or two or more thereof may be used in combination. That is, these dihydroxy compounds are sometimes obtained as a mixture of isomers for a production-related reason and in this case, the isomer mixture can be used as it is. For example, a mixture of 3,8-bis(hydroxymethyl)tricyclo[5.2.1.0$^{2.6}$]decane, 3,9-bis(hydroxymethyl)tricyclo[5.2.1.0$^{2.6}$]decane, 4,8-bis(hydroxymethyl)tricyclo[5.2.1.0$^{2.6}$]decane and 4,9-bis(hydroxymethyl)tricyclo[5.2.1.0$^{2.6}$]decane can be used.

Among specific examples of the dihydroxy compound represented by formula (4), cyclohexanedimethanols

are preferred, and in view of availability and ease of handling, 1,4-cyclohexanedimethanol, 1,3-cyclohexanedimethanol and 1,2-cyclohexanedimethanol are preferred, and 1,4-cyclohexanedimethanol highly effective in imparting toughness is more preferred.

<Dihydroxy Compound Represented by Formula (5)>

The dihydroxy compound represented formula (5) is a compound having on $R^7$ a substituted or unsubstituted alkylene group with a carbon number of 2 to 10, preferably a carbon number of 2 to 5. p is an integer of 2 to 50, preferably from 2 to 30.

The dihydroxy compound represented by formula (5) includes, for example, diethylene glycol, triethylene glycol, a polyethylene glycol, dipropylene glycol, tripropylene glycol, polypropylene glycol, and polytetramethylene glycol. Among these, diethylene glycol, triethylene glycol, and a polyethylene glycol having a number average molecular weight of 150 to 4,000 are preferred, and a polyethylene glycol having a number average molecular weight of 300 to 2,500, particularly a number average molecular weight of 600 to 1,500, is more preferred.

One of these compounds may be used alone, or two or more thereof may be used in combination.

<Dihydroxy Compound Represented by Formula (6)>

The dihydroxy compound represented formula (6) is a dihydroxy compound having on $R^8$ a substituted or unsubstituted alkylene group with a carbon number of 2 to 20, preferably a carbon number of 2 to 10, or a group represented by the following formula (6A). In the case where the alkylene group of $R^8$ has a substituent, the substituent includes an alkyl group having a carbon number of 1 to 5.

[Chem. 7]

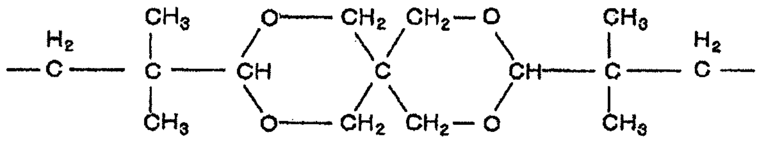

(6A)

Out of the dihydroxy compounds represented by formula (6), the dihydroxy compound where $R^8$ is an alkylene group having a carbon number of 2 to 20 specifically includes, for example, ethylene glycol, 1,2-propanediol, 1,3-propanediol, 1,2-butanediol, 1,4-butanediol, 1,6-hexanediol, and neopentyl glycol, and in view of availability, ease of handling, high reactivity at the polymerization, and color hue of the obtained polymer, 1,3-propanediol and 1,6-hexanediol are preferred. According to the performance required of the obtained polycarbonate resin, one of these compounds may be used alone or two or more thereof may be used in combination.

The dihydroxy compound where $R^8$ is an acetal ring group represented by formula (6A) includes spiroglycol and the like, but a dihydroxy compound having an acetal structure works out to a crosslinking point during the polymerization reaction to readily cause a crosslinking reaction and may incur a trouble in the polymerization reaction or generate a gelled foreign matter, giving rise to stretch or rupture at the production of a retardation film or leading to a film defect. Therefore, in the polycarbonate resin of the present invention, the content of the structural unit derived from a dihydroxy compound having an acetal structure is preferably 10 mol% or less, more preferably 5 mol% or less, still more preferably 2 mol% or less, and most preferably 0 mol%, based on structural units derived from all dihydroxy compounds.

Among structural units derived from dihydroxy compounds represented by formulae (2) to (6), the polycarbonate resin of the present invention preferably contains, as the structural unit (a), a structural unit derived from a dihydroxy compound represented by formula (2) and structural units derived from one or more dihydroxy compounds selected from the group consisting of a dihydroxy compound represented by formula (3), a dihydroxy compound represented by formula (4), a dihydroxy compound represented by formula (5) and a dihydroxy compound represented by formula (6), because various physical properties such as melt viscosity of the polycarbonate resin can be adjusted to those suitable for molding of a film or the optical properties can be more easily controlled.

Also, among a structural unit derived from a dihydroxy compound represented by formula (3), a structural unit derived from a dihydroxy compound represented by formula (4), a structural unit derived from a dihydroxy compound represented by formula (5) and a structural unit derived from a dihydroxy compound represented by formula (6), the polycarbonate resin preferably contains a structural unit derived from a dihydroxy compound represented by formula (4) and/or a structural unit derived from a dihydroxy compound represented by formula (5), more preferably a structural unit derived from a dihydroxy compound represented by formula (5).

<Structural Unit (b)>

The compound suitably used for the structural unit (b) of the polycarbonate resin of the present invention includes a dihydroxy compound represented by the following formula (1):

[Chem. 8]

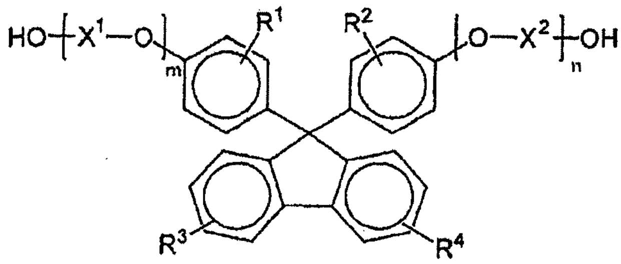

(1)

(wherein each of $R^1$ to $R^4$ independently represents a hydrogen atom, a substituted or unsubstituted alkyl group having a carbon number of 1 to 20, a substituted or unsubstituted cycloalkyl group having a carbon number of 6 to 20, or a substituted or unsubstituted aryl group having a carbon number of 6 to 20, and the same or different groups are substituted as respective substituents on four benzene rings; each of $X^1$ and $X^2$ independently represents a substituted or unsubstituted alkylene group having a carbon number of 2 to 10, a substituted or unsubstituted cycloalkylene group having a carbon number of 6 to 20, or a substituted or unsubstituted arylene group having a carbon number of 6 to 20; and each of m and n independently represents an integer of 0 to 5).

Here, the substituent which may be substituted on $R^1$ to $R^4$, $X^1$ and $X^2$ includes, for example, an alkoxy group such as methoxy group, ethoxy group and propoxy group, and an aryl group such as phenyl group and naphthyl group.

Each of $R^1$ to $R^4$ is independently, preferably a hydrogen atom, a substituted or unsubstituted alkyl group having a carbon number of 1 to 10, or a substituted or unsubstituted aryl group having a carbon number of 6 to 15, and it is preferred that $R^1$ and $R^2$ out of $R^1$ to $R^4$ are an unsubstituted alkyl group or all of $R^1$ to $R^4$ are a hydrogen atom. In the case where $R^1$ to $R^4$ are a substituent except for a hydrogen atom, the substituent is preferably bonded on the 3- or 5-position with respect to the bonding position of the benzene ring to the fluorene ring, and the unsubstituted alkyl group is preferably a methyl group or an ethyl group.

Each of $X^1$ and $X^2$ is independently, preferably an alkylene group having a carbon number of 1 to 4, more preferably an unsubstituted methylene group, an unsubstituted ethylene group or an unsubstituted propylene group, and it is preferred that $X^1$ and $X^2$ are the same.

Each of m and n is independently an integer of 0 to 5 and is preferably 1 or more, because the polymerization degree of the polycarbonate resin can be controlled, the glass transition temperature of the polycarbonate resin can be adjusted to a temperature suitable for melt formation, or the toughness of the obtained film can be enhanced. Also, m and n are preferably the same integer.

In particular, the dihydroxy compound represented by formula (1) preferably has a bilaterally symmetric structure with the axis of symmetry being the symmetric axis of the fluorene ring.

Specific examples of the dihydroxy compound represented by formula (1) include 9,9-bis(4-hydroxyphenyl)fluorene, 9,9-bis(4-hydroxy-3-methylphenyl)fluorene, 9,9-bis(4-hydroxy-3-ethylphenyl)fluorene, 9,9-bis(4-hydroxy-3-n-propylphenyl)fluorene, 9,9-bis(4-hydroxy-3-isopropylphenyl)fluorene, 9,9-bis(4-hydroxy-3-n-butylphenyl)fluorene, 9,9-bis(4-hydroxy-3-sec-butylphenyl)fluorene, 9,9-bis(4-hydroxy-3-tert-propylphenyl)fluorene, 9,9-bis(4-hydroxy-3-cyclohexylphenyl)fluorene, 9,9-bis(4-hydroxy-3-phenylphenyl)fluorene, 9,9-bis(4-(2-hydroxyethoxy)phenyl)fluorene, 9,9-bis(4-(2-hydroxyethoxy)-3-methylphenyl)fluorene, 9,9-bis(4-(2-hydroxyethoxy)-3-isopropylphenyl)fluorene, 9,9-bis(4-(2-hydroxyethoxy)-3-isobutylphenyl)fluorene, 9,9-bis(4-(2-hydroxyethoxy)-3-tert-butylphenyl)fluorene, 9,9-bis(4-(2-hydroxyethoxy)-3-cyclohexylphenyl)fluorene, 9,9-bis(4-(2-hydroxyethoxy)-3-phenylphenyl)fluorene, 9,9-bis(4-(2-hydroxyethoxy)-3,5-dimethylphenyl)fluorene, 9,9-bis(4-(2-hydroxyethoxy)-3-tert-butyl-6-methylphenyl)fluorene, and 9,9-bis(4-(3-hydroxy-2,2-dimethylpropoxy)phenyl)fluorene. From the standpoint of imparting optical properties, 9,9-bis(4-hydroxy-3-methylphenyl)fluorene, 9,9-bis(4-hydroxyphenyl)fluorene, 9,9-bis(4-(2-hydroxyethoxy)phenyl)fluorene and 9,9-bis(4-(2-hydroxyethoxy)-3-methylphenyl)fluorene are preferred, and from the standpoint of imparting toughness to the film, 9,9-bis(4-(2-hydroxyethoxy)phenyl)fluorene is more preferred.

As for the structural unit derived from the dihydroxy compound represented by formula (1), the polycarbonate resin of the present invention may contain only one structural unit or may contain two or more structural units.

<Another Structural Units>

The polycarbonate resin of the present invention may further contain a structural unit derived from another dihydroxy compound, in addition to the structural units derived from dihydroxy compounds represented by formulae (1) to (6).

Other examples of the another dihydroxy compound include bisphenols.

The bisphenols include, for example, 2,2-bis(4-hydroxyphenyl)propane (=bisphenol A), 2,2-bis(4-hydroxy-3,5-dimethylphenyl)propane, 2,2-bis(4-hydroxy-3,5-diethylphenyl)propane, 2,2-bis(4-hydroxy-(3,5-diphenyl)phenyl)propane, 2,2-bis(4-hydroxy-3,5-dibromophenyl)propane, 2,2-bis(4-hydroxyphenyl)pentane, 2,4'-dihydroxy-diphenylmethane, bis(4-hydroxyphenyl)methane, bis(4-hydroxy-5-nitrophenyl)methane, 1,1-bis(4-hydroxyphenyl)ethane, 1,1-bis(4-hydroxyphenyl)-2-ethylhexane, 1,1-bis(4-hydroxyphenyl)decane, 2,2-bis(4-hydroxyphenyl)octane, 2,2-bis(4-hydroxyphenyl)nonane, 2,2-bis(4-hydroxyphenyl)decane, 1,3-bis[2-(4-hydroxyphenyl)-2-propyl]benzene, 3,3-bis(4-hydroxyphenyl)pentane, 1,1-bis(4-hydroxyphenyl)cyclohexane, bis(4-hydroxyphenyl)sulfone, 2,4'-dihydroxydiphenylsulfone, bis(4-hydroxyphenyl)sulfide, 4,4'-dihydroxydiphenyl ether, 4,4'-dihydroxy-3,3'-dichlorodiphenyl ether, and 4,4'-dihydroxy-2,5-diethoxydiphenyl ether. Among these, in view of ease of handling, availability and adjustment to a glass transition temperature suitable for melt film formation, 2,2-bis(4-hydroxy phenyl)propane, 1,1-bis(4-hydroxyphenyl)-2-ethylhexane, 1,1-bis(4-hydroxyphenyl)decane are preferred, and 2,2-bis(4-hydroxyphenyl)propane is more preferred.

One of these compounds may be used alone, or two or more thereof may be used in combination. However, a dihydroxy compound having an aromatic ring in the structure, other than the dihydroxy compound represented by formula (1), may adversely affect the optical properties, and therefore, the structural unit derived from such a dihydroxy compound is preferably used in a ratio of 50 mol% or less, more preferably 20 mol% or less, still more preferably 5 mol% or less, based on the total of structural units derived from dihydroxy compounds in the polycarbonate resin. In particular, it is preferred that the polycarbonate resin of the present invention does not contain a structural unit derived from a dihydroxy compound having an aromatic ring in the structure, other than the dihydroxy compound represented by formula (1).

In addition, as the polymer forming the retardation film of the present invention, a polyester carbonate where a part of the carbonate bond of the polycarbonate above is substituted by a dicarboxylic acid structure may be also used. The dicarboxylic acid compound forming the above-described dicarboxylic acid structure includes, for example, an aromatic dicarboxylic acid such as terephthalic acid, phthalic acid, isophthalic acid, 4,4'-diphenyldicarboxylic acid, 4,4'-diphenyl ether dicarboxylic acid, 4,4'-benzophenonedicarboxylic acid, 4,4'-diphenoxyethanedicarboxylic acid, 4,4'-diphenylsulfonedicarboxylic acid and 2,6-naphthalenedicarboxylic acid, an alicyclic dicarboxylic acid such as 1,2-cyclohexanedicarboxylic acid, 1,3-cyclohexanedicarboxylic acid and 1,4-cyclohexanedicarboxylic acid, and an aliphatic dicarboxylic acid such as malonic acid, succinic acid, glutaric acid, adipic acid, pimelic acid, suberic acid, azelaic acid and sebacic acid. In view of heat resistance and heat stability of the obtained polymer, an aromatic dicarboxylic acid is preferred; in view of ease of handling, terephthalic acid and isophthalic acid are more preferred; and terephthalic acid is still more preferred. With respect to these dicarboxylic acid components, the dicarboxylic acid itself may be used as the raw material of the polymer of the present invention, but according to the production method, a dicarboxylic acid ester such as methyl ester form and phenyl ester form, or a dicarboxylic acid derivative such as dicarboxylic acid halide, may also be used as the raw material.

In the polyester carbonate according to the present invention, assuming that the total of structural units derived from all dihydroxy compounds and all carboxylic acid compounds is 100 mol%, the content ratio of the structural unit derived from a dicarboxylic acid compound is preferably 45 mol% or less, more preferably 40 mol% or less. If the content ratio of the dicarboxylic acid compound exceeds 45 mol%, the polymerizability is reduced, and the polymerization may not proceed until the desired molecular weight is achieved.

<Percentage Content of Each Structural unit>

In the polycarbonate resin of the present invention, when the polycarbonate resin of the present invention contains, as the structural unit (b), a structural unit derived from a dihydroxy compound represented by formula (1) and contains, as the structural unit (a), a structural unit derived from dihydroxy compounds represented by formula (2) to (6), the percentage content of each structural unit is preferably as follows.

That is, the percentage content of the structural unit derived from a dihydroxy compound represented by formula (1) is preferably 40 wt% or more, more preferably 45 wt% or more, still more preferably 50 wt% or more, based on the total of structural units derived from dihydroxy compounds contained in the polycarbonate resin of the present invention. If the percentage content of the structural unit is too small, the wavelength dispersion property of the obtained retardation film may not be satisfactory. Also, if the percentage content of the structural unit is too large, the value of formula (A) becomes excessively large, resulting in unsatisfactory optical properties, and therefore, the percentage content is preferably 95 wt% or less, more preferably 90 wt% or less, still more preferably 85 wt% or less, yet still more preferably 80

wt% or less, based on the total of structural units derived from dihydroxy compounds contained in the polycarbonate resin of the present invention.

In the present invention, the percentage content of the structure derived from a dihydroxy compound, specified in wt%, is the percentage content of the repeating unit structure of a carbonate bond-containing dihydroxy compound based on the total weight of the polycarbonate resin.

Furthermore, in the case where the polycarbonate resin of the present invention contains a structural unit derived from a dihydroxy compound represented by formula (2), the percentage content of the structural unit derived from a dihydroxy compound represented by formula (2) is preferably 20 wt% or more, more preferably 25 wt% or more, still more preferably 30 wt% or more, based on the total of structural units derived from dihydroxy compounds contained in the polycarbonate resin. If the percentage content of the structural unit is too small, the phase retardation of the obtained retardation film may become excessively small. However, if the percentage content of the structural unit is too large, the glass transition temperature of the polycarbonate resin of the present invention may become excessively high, making it difficult to mold a film, and therefore, the percentage content is preferably 50 wt% or less, more preferably 45 wt% or less, based on the total of structural units derived from dihydroxy compounds contained in the polycarbonate resin.

Also, in the case where the polycarbonate resin of the present invention contains structural units derived from one or more dihydroxy compounds selected from a dihydroxy compound represented by formula (3), a dihydroxy compound represented by formula (4), a dihydroxy compound represented by formula (5) and a dihydroxy compound represented by formula (6), the content thereof is preferably from 0.1 wt% to less than 4.5 wt%, more preferably from 0.1 to 4.0 wt%, still more preferably from 0.2 to 3.0 wt%, based on the total of structural units derived from dihydroxy compounds contained in the polycarbonate resin. By virtue of containing structural units derived from dihydroxy compounds represented by formulae (3) to (6) in an amount of not less than the lower limit above in the polycarbonate resin, the melt film formation of the polycarbonate resin can be prevented from generating a foreign matter or a bubble due to heat or causing coloration of the polycarbonate resin. However, if the content of the structural unit is too large, the optical properties of the retardation film may be changed due to environmental change such as temperature.

Among others, the polycarbonate resin of the present invention is preferably a polycarbonate resin having a glass transition temperature of 120 to 160°C, more preferably from 130 to 155°C, still more preferably from 140 to 150°C. If the glass transition temperature is too high, melt film formation may become difficult, whereas if the glass transition temperature is too low, the optical properties of the retardation film may be changed due to environmental change.

Incidentally, out of structural units derived from dihydroxy compounds represented by formulae (3) to (6), the polycarbonate resin of the present invention may contain only a structural unit derived from a dihydroxy compound represented by any one formula or may contain structural units derived from dihydroxy compounds represented by two or more formulae, and the dihydroxy compound from which the structural unit that should be contained is derived is appropriately determined to satisfy the required properties according to usage of the formed retardation film, but it is particularly preferred to contain at least one structural unit derived from dihydroxy compounds represented by formulae (3) to (6), in addition to the structural units derived from dihydroxy compounds represented by formulae (1) and (2). In this case, the content of the structural unit derived from dihydroxy compounds represented by formulae (3) to (6) is preferably from 0.1 wt% to less than 4.5 wt%, more preferably from 0.1 to 4.0 wt%, still more preferably from 0.2 to 3.0 wt%, based on the total of structural units derived from dihydroxy compounds contained in the polycarbonate resin.

Above all, the polycarbonate resin preferably contains a structural unit derived from a dihydroxy compound represented by formula (5), in addition to structural units derived from dihydroxy compounds represented by formulae (1) and (2), and it is more favorable to contain a polyethylene glycol having a number average molecular weight of 150 to 4,000, preferably a polyethylene glycol having a number average molecular weight of 300 to 2,000, more preferably a polyethylene glycol having a number average molecular weight of 600 to 1,500, in an amount of 0.5 to 4 wt%, preferably from 1 to 3 wt%, based on the total of structural units derived from dihydroxy compounds in the polycarbonate resin.

[Production Method of Polycarbonate Resin of the Present Invention]

The polycarbonate resin for use in the present invention can be produced by a polymerization method employed in general, and the polymerization method may be either an interfacial polymerization method using phosgene or a melt polymerization method of reacting a dihydroxy compound with a carbonic acid diester through transesterification, but a melt polymerization method of reacting a dihydroxy compound and a carbonic acid diester in the presence of a polymerization catalyst without using a solvent is preferred, because in an interfacial polymerization, not only phosgene having high toxicity or a chlorine-containing solvent giving rise to environmental destruction, such as methylene chloride and chlorobenzene, must be used but also when even a slight amount of chlorine-containing solvent remains in the polycarbonate, the chlorine-containing component volatilizing during original film formation or stretching operation may cause corrosion of or damage to the film-forming apparatus or stretching apparatus or after the film is assembled as a retardation plate, may adversely affect other members.

On the other hand, the polyester carbonate resin for use in the present invention can also be produced by a

polymerization method employed in general, and the polymerization may be, for example, either a method of reacting a dihydroxy compound, a dicarboxylic acid or a dicarboxylic acid halide, and phosgene in the presence of a solvent, or a melt polymerization method of reacting a dihydroxy compound, a dicarboxylic acid or a dicarboxylic acid ester, and a carbonic acid diester through transesterification without using a solvent, but for the same reason as above, a melt polymerization method of reacting a dihydroxy compound, a dicarboxylic acid or a dicarboxylic acid ester, and a carbonic acid diester in the presence of a polymerization catalyst is preferred.

The carbonic acid diester used in the melt polymerization method includes a carbonic acid diester usually represented by the following formula (10):

[Chem. 9]

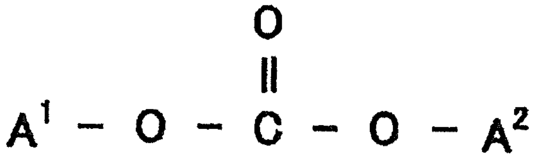

(10)

(wherein each of $A^1$ and $A^2$ independently represents a substituted or unsubstituted aliphatic group having a carbon number of 1 to 18 or a substituted or unsubstituted aromatic group having a carbon number of 6 to 18).

The carbonic acid diester represented by formula (10) includes, for example, diaryl carbonates typified by diphenyl carbonate, ditolyl carbonate, bis(chlorophenyl)carbonate, m-cresyl carbonate, dinaphthyl carbonate and bis(biphenyl)carbonate, and dialkyl carbonates typified by dimethyl carbonate, diethyl carbonate, dibutyl carbonate and dicyclohexyl carbonate. Among these, diaryl carbonates are preferably used, and diphenyl carbonate is more preferably used.

One of these carbonic acid diesters may be used alone, or two or more thereof may be mixed and used.

In the case of obtaining a polycarbonate resin, the carbonic acid diester is preferably used in a molar ratio of 0.90 to 1.10, more preferably from 0.96 to 1.05, still more preferably from 0.98 to 1.03, based on all dihydroxy compounds used for the reaction. Also, in the case of obtaining a polyester carbonate resin, the carbonic acid diester is preferably used in a molar ratio of 0.90 to 1.10, more preferably from 0.96 to 1.05, still more preferably from 0.98 to 1.03, based on the molar number of dihydroxy compound after subtracting the molar number of all dicarboxylic acids from the molar number of all dihydroxy compounds. If this molar ratio is less than 0.90, the terminal hydroxyl group of the polycarbonate resin or polyester carbonate resin produced is increased, and the heat stability may be deteriorated or a desired high-molecular-weight polymer may not be obtained. Also, if the molar ratio exceeds 1.10, not only the transesterification reaction rate may be decreased under the same conditions, making it difficult to produce a polycarbonate resin or polyester carbonate resin having a desired molecular weight, but also the amount of carbonic acid diester remaining in such a polymer is increased and the remaining carbonic acid diester may volatilize during original film formation or stretching to cause a defect in the film.

As the polymerization catalyst (transesterification catalyst) in the melt polymerization, an alkali metal compound and/or an alkaline earth metal compound are used. Together with an alkali metal compound and/or an alkali metal compound, a basic compound such as basic boron compound, basic phosphorus compound, basic ammonium compound and amine-based compound may be used in combination, but it is particularly preferred to use only an alkali metal compound and/or an alkaline earth metal compound.

The alkali metal compound used as the polymerization catalyst includes, for example, sodium hydroxide, potassium hydroxide, lithium hydroxide, cesium hydroxide, sodium hydrogencarbonate, potassium hydrogencarbonate, lithium hydrogencarbonate, cesium hydrogencarbonate, sodium carbonate, potassium carbonate, lithium carbonate, cesium carbonate, sodium acetate, potassium acetate, lithium acetate, cesium acetate, sodium stearate, potassium stearate, lithium stearate, cesium stearate, sodium borohydride, potassium borohydride, lithium borohydride, cesium borohydride, sodium borophenylate, potassium borophenylate, lithium borophenylate, cesium borophenylate, sodium benzoate, potassium benzoate, lithium benzoate, cesium benzoate, disodium hydrogenphosphate, dipotassium hydrogenphosphate, dilithium hydrogenphosphate, dicesium hydrogenphosphate, disodium phenylphosphate, dipotassium phenylphosphate, dilithium phenylphosphate, dicesium phenylphosphate, an alcoholate or phenolate of sodium, potassium, lithium and cesium, and disodium, dipotassium, dilithium and dicesium salts of bisphenol A.

The alkaline earth metal compound includes, for example, calcium hydroxide, barium hydroxide, magnesium hydroxide, strontium hydroxide, calcium hydrogencarbonate, barium hydrogencarbonate, magnesium hydrogencarbonate, strontium hydrogencarbonate, calcium carbonate, barium carbonate, magnesium carbonate, strontium carbonate, calcium acetate, barium acetate, magnesium acetate, strontium acetate, calcium stearate, barium stearate, magnesium stearate, and strontium stearate. Among these, in view of polymerization activity, a magnesium compound and

a calcium compound are preferred.

In the description of the present invention, the terms "alkali metal" and "alkaline earth metal" are used as terms respectively having the same meanings as "Group 1 element" and "Group 2 element" in the long-form periodic table (Nomenclature of Inorganic Chemistry IUPAC Recommendations 2005).

One of these alkali metal compounds and/or alkaline earth metal compounds may be used alone, or two or more thereof may be used in combination.

Specific examples of the basic boron compound used in combination with the alkali metal compound and/or alkaline earth metal compound include sodium, potassium, lithium, calcium, barium, magnesium and strontium salts of tetramethylboron, tetraethylboron, tetrapropylboron, tetrabutylboron, trimethylethylboron, trimethylbenzylboron, trimethylphenylboron, triethylmethylboron, triethylbenzylboron, triethylphenylboron, tributylbenzylboron, tributylphenylboron, tetraphenylboron, benzyltriphenylboron, methyltriphenylboron and butyltriphenylboron.

The basic phosphorus compound includes, for example, triethylphosphine, tri-n-propylphosphine, triisopropylphosphine, tri-n-butylphosphine, triphenylphosphine, tributylphosphine, and a quaternary phosphonium salt.

The basic ammonium compound includes, for example, tetramethylammonium hydroxide, tetraethylammonium hydroxide, tetrapropylammonium hydroxide, tetrabutylammonium hydroxide, trimethylethylammonium hydroxide, trimethylbenzylammonium hydroxide, trimethylphenylammonium hydroxide, triethylmethylammonium hydroxide, triethylbenzylammonium hydroxide, triethylphenylammonium hydroxide, tributylbenzylammonium hydroxide, tributylphenylammonium hydroxide, tetraphenylammonium hydroxide, benzyltriphenylammonium hydroxide, methyltriphenylammonium hydroxide, and butyltriphenylammonium hydroxide.

The amine-based compound includes, for example, 4-aminopyridine, 2-aminopyridine, N,N-dimethyl-4-aminopyridine, 4-diethylaminopyridine, 2-hydroxypyridine, 2-methoxypyridine, 4-methoxypyridine, 2-dimethylaminoimidazole, 2-methoxyimidazole, imidazole, 2-mercaptoimidazole, 2-methylimidazole, and aminoquinoline.

One of these basic compounds also may be used alone, or two or more thereof may be used in combination.

In the case where an alkali metal compound and/or an alkaline earth metal compound is used, the amount of the polymerization catalyst used is, in terms of metal, usually from 0.1 to 100 μmol, preferably from 0.5 to 50 μmol, more preferably from 1 to 25 μmol, per mol of all dihydroxy compounds used for the reaction. If the amount of the polymerization catalyst used is too small, polymerization activity necessary for producing a polycarbonate resin having a desired molecular weight is not obtained, and on the other hand, if the amount of the polymerization catalyst used too large, the color hue of the obtained polycarbonate resin may be deteriorated or a by-product may be produced to reduce the flowability or cause many gel occurrences, making it difficult to produce a polycarbonate resin of desired quality.

Also, in the case of obtaining a polyester carbonate, together or not together with the basic compound, a transesterification catalyst such as titanium compound, tin compound, germanium compound, antimony compound, zirconium compound, lead compound and osmium compound may also be used. The amount of such a transesterification catalyst used is, in terms of metal, usually from 10 μmol to 1 mmol, preferably from 20 to 800 μmol, more preferably from 50 to 500 μmol, per mol of all dihydroxy compounds used for the reaction.

In producing the polycarbonate resin of the present invention, the dihydroxy compound represented by formula (1) may be fed as a solid or may be heated and fed in a molten state, but when the melting point of the dihydroxy compound represented by formula (1) is higher than 150°C, if the dihydroxy compound is melted alone, coloration or the like may occur, and therefore, the dihydroxy compound is preferably dissolved in another dihydroxy compound having a melting point lower than that of the dihydroxy compound represented by formula (1) and then fed.

As for one or more dihydroxy compounds selected from the group consisting of a dihydroxy compound represented by formula (2), a dihydroxy compound represented by formula (3), a dihydroxy compound represented by formula (4), a dihydroxy compound represented by formula (5) and a dihydroxy compound represented by formula (6), each compound may be fed as a solid, may be heated and then fed in a molten state, or in the case of being soluble in water, may be fed in the form of an aqueous solution. The same applies also to another dihydroxy compound and the dicarboxylic acid compound.

In the method for producing the polymer of the present invention by a melt polymerization method, a dihydroxy compound and, if desired, a dicarboxylic acid compound are reacted with a carbonic acid diester in the presence of a polymerization catalyst. The polymerization is usually performed by a multistage process consisting of two or more stages and may be performed by a process in two or more stages by using one reactor but changing the conditions or may be performed by a process in two or more stages by using two or more reactors and changing the conditions between respective reactors, but in view of production efficiency, the polymerization is performed using two or more, preferably three or more, more preferably from three to five, still more preferably four, reactors. The polymerization reaction may be of any type of batch system, continuous system, and a combination of batch system and continuous system, but in view of production efficiency and stability of quality, a continuous system is preferred.

In the present invention, the polymerization catalyst may be added to a raw material preparation tank or a raw material storage tank or may be added directly to a polymerization tank, but in view of feed stability and polymerization control, the catalyst is preferably fed in the form of an aqueous solution or a phenol solution by providing a catalyst feed

line in the middle of a raw material line before feeding a polymerization tank.

If the polymerization reaction temperature is too low, a decrease in the productivity or an increase in the heat history added to the product may be involved, whereas if the temperature is too high, not only volatilization of a monomer may occur but also decomposition or coloration of the polymer of the present invention may be promoted.

In the melt polymerization reaction to obtain the polymer of the present invention, it is important to control the balance between the temperature and the inner pressure of the reaction system. If either one of the temperature and the pressure is changed too early, an unreacted monomer may be distilled off from the reaction system to change the molar ratio between the dihydroxy compounds and the carbonic diester, as a result, a desired polymer may not be obtained.

Specifically, the reaction in the first stage is performed at a temperature of, in terms of maximum internal temperature of the polymerization reactor, from 130 to 250°C, preferably from 140°C to 240°C, more preferably from 150 to 230°C, under a pressure of 110 to 1 kPa, preferably from 70 to 3 kPa, more preferably from 30 to 5 kPa (absolute pressure), for 0.1 to 10 hours, preferably from 0.5 to 3 hours, while removing the generated monohydroxy compound by distillation out of the reaction system.

The reaction in the second and subsequent stages is performed by gradually lowering the pressure of the reaction system from the pressure in the first stage and finally setting the pressure (absolute pressure) of the reaction system to 5 kPa or less, preferably 3 kPa, at a maximum internal temperature of 210 to 270°C, preferably from 220 to 250°C, for usually from 0.1 to 10 hours, preferably from 0.5 to 6 hours, more preferably from 1 to 3 hours, while removing the continuously occurring monohydroxy compound out of the reaction system.

Above all, in order to suppress coloration or thermal deterioration of the polymer of the present invention and obtain a polymer excellent in the color hue and light resistance, the maximum internal temperature in all reaction stages is preferably 270°C or less, more preferably 260°C or less. Also, in order to prevent the polymerization rate from lowering in the latter half of the polymerization reaction and thereby keep the deterioration due to heat history to a minimum, a horizontal reactor excellent in the plug flow and interface renewal is preferably used in the final stage of polymerization.

After the polycondensation as described above, the polymer of the present invention is usually cooled/solidified and then pelletized by a rotary cutter or the like.

The method for pelletization is not limited but includes, for example, a method where the polymer is withdrawn in a molten state from the final polymerization reactor, cooled/solidified in the form of a strand and then pelletized, a method where the resin is fed in a molten state from the final polymerization reactor to a single- or twin-screw extruder, melt-extruded, cooled/solidified and then pelletized, and a method where the polymer is withdrawn in a molten state from the final polymerization reactor, cooled/solidified in the form of a strand and once pelletized and thereafter, the resin is again fed to a single- or twin-screw extruder, melt-extruded, cooled/solidified and then pelletized. As described later, when a large amount of by-product monohydroxy compound is contained in the polymer, after the polymer is processed into a retardation film, a change in optical properties may be incurred by the environmental change, and therefore, the monohydroxy compound is preferably removed from the polymer of the present invention by using an extruder. Above all, a method where the resin is fed in a molten state from the final polymerization reactor to a single- or twin-screwed extrude having a single vent port or a plurality of vent ports, melt-extruded while removing the monohydroxy compound by reducing the pressure at the vent port, then cooled/solidified and pelletized, is preferred.

<Polymer of the Present Invention>

<Reduced Viscosity>

The molecular weight of the polymer of the present invention, such as polycarbonate resin of the present invention, can be expressed in terms of reduced viscosity. The reduced viscosity of the polymer of the present invention is measured, as described later in the paragraph of Examples, at a temperature of 20.0±0.1°C by means of an Ubbelohde viscometer after precisely adjusting the polymer concentration to 0.6 g/dL by using methylene chloride as a solvent. The reduced viscosity of the polymer of the present invention is not particularly limited but is preferably 0.30 dL/g or more, more preferably 0.35 dL/g or more. The upper limit of the reduced viscosity is preferably 1.20 dL/g or less, more preferably 1.00 dL/g or less, still more preferably 0.80 dL/g or less, yet still more preferably 0.60 dL/g or less, even yet still more preferably 0.50 dL/g or less.

If the reduced viscosity of the polymer falls below the lower limit above, there may arise a problem that the mechanical strength of the retardation film obtained is reduced. On the other hand, if the reduced viscosity exceeds the upper limit above, a problem of decrease in the flowability at the molding into a film may arise to in turn, reduce the productivity, a foreign matter and the like in the polymer can be hardly removed by filtration, making it difficult to decrease the foreign matter, and a bubble may be entrained during film molding or a thickness unevenness may be produced, leaving the possibility that the film quality may deteriorate.

<Melt Viscosity>

In the polymer of the present invention, such as polycarbonate resin of the present invention, the melt viscosity at a temperature of 240°C and a shear rate of 91.2 $sec^{-1}$ is preferably from 500 to 5,000 Pa•sec, more preferably from 1,000 to 4,000 Pa•sec, still more preferably from 1,500 to 3,000 Pa•sec.

If the melt viscosity of the polymer falls below the lower limit above, there may arise a problem that the mechanical strength of the retardation film obtained is reduced. On the other hand, if the melt viscosity exceeds the upper limit above, a problem of decrease in the flowability at the molding into a film may arise to in turn, reduce the productivity, a foreign matter and the like in the polymer can be hardly removed by filtration, making it difficult to decrease the foreign matter, and a bubble may be entrained during film molding or a thickness unevenness may be produced, leaving the possibility that the film quality may deteriorate.

<Photoelastic Coefficient>

With respect to a sheet obtained by press-molding the polymer of the present invention, such as polycarbonate resin of the present invention, by the method described later in the paragraph of Examples, the photoelastic coefficient measured by the later-described method is preferably $45\times10^{-12}$ $Pa^{-1}$ or less, more preferably $35\times10^{-12}$ $Pa^{-1}$ or less. If the photoelastic coefficient is too large, there arises a problem that when the retardation film obtained by molding the polymer is laminated to a circularly polarizing plate and the resulting polarizing plate is mounted in an image display device, a partial stress attributable to a stress at the lamination is imposed on the retardation film due to heat in the viewing environment or from a backlight and a non-uniform retardation change is produced to cause a significant deterioration of the image quality. In view of ease of production, the photoelastic coefficient of the polymer of the present invention is usually $-10\times10^{-12}$ $Pa^{-1}$ or more, preferably $0\times10^{-12}$ $Pa^{-1}$ or more.

<Content of Monohydroxy Compound>

As described above, the polymer of the present invention is produced by a melt polymerization method using a carbonic acid diester as the raw material and thereby can be obtained without by any means using phosgene having high toxicity or a chlorine-containing solvent giving rise to environmental destruction, but in the melt polymerization method, the polymerization reaction involves occurrence of a by-product monohydroxy compound such as phenol, and this compound may remain in the polymer of the present invention and volatilize during film formation or stretching, causing an odor or a defect of film. Also, after the polymer of the present invention is processed into a retardation film, the monohydroxy compound remaining in the film may cause a change in optical properties of the retardation film due to environmental change, and therefore, the upper limit of the concentration of the monohydroxy compound contained in the polymer of the present invention is usually 0.3 wt%, preferably 0.2 wt%, more preferably 0.15 wt%. As for the lower limit, the concentration may be preferably smaller so as to solve the above-described problem, but it is difficult in the melt polymerization method to eliminate the monohydroxy compound remaining in the polymer to zero, and the removal requires an enormous labor. Therefore, the lower limit is usually 0.001 wt%, preferably 0.005 wt%, more preferably 0.01 wt%. The content of the monohydroxy compound in the retardation film can be quantitatively determined by a known method such as high-performance liquid chromatography after dissolving the retardation film in a solvent.

In order to reduce the amount of the monohydroxy compound remaining in the polymer of the present invention, it is effective to devolatilize the polymer by an extruder as above and to reduce the pressure in the final polymerization tank to 3 kPa or less, preferably 2 kPa or less, but when the dihydroxy compound represented by formula (1) is used as the raw material of the polymer of the present invention, the equilibrium constant is large and not only an excessive reduction in the pressure involves an abrupt rise in the molecular weight and makes it difficult to obtain a uniform product but also the monohydroxy compound remaining in the equilibrium is proportional to the product of terminal group concentrations of the polymer. Therefore, the polymer is preferably produced by setting the terminal group concentration of the polymer to a hydroxyl group excess or an aryl group excess and thereby biasing the terminal group balance. Among others, in view of heat stability, the hydroxyl group terminal concentration is preferably set to 30 $\mu$eq/g or less, more preferably 20 $\mu$eq/g or less. The hydroxy group terminal concentration can be quantitatively determined by $^1$H-NMR or the like.

<Blending with Other Resins>

In the polymer of the present invention, one or more kinds of polymers can be blended so as to impart film moldability, stretchability and flexibility. The polymer blended includes, for example, a polymer composed of an aliphatic hydrocarbon structure constituted by an $\alpha$-olefin such as ethylene and propylene, butadiene, isoprene or a hydrogenation product thereof, a polymer composed of an aromatic hydrocarbon structure such as styrene and $\alpha$-methylstyrene, a

polymer composed of an acrylic compound such as acrylonitrile, acrylic acid, acrylic acid ester, methacrylic acid and methacrylic acid ester, a copolymer thereof typified by AS resin, ABS resin and SEBS resin, a polycarbonate resin, a polyester carbonate resin, a polyester resin, a polyamide resin, a polyphenylene ether resin, and a polyimide resin. Above all, when the glass transition temperature of the polymer of the present invention is 140°C or more, blending a polymer having a glass transition temperature of 100°C or less produces a great effect of preventing the optical properties of the retardation film from changing due to environmental change of the film while improving the film moldability, stretchability and flexibility. In particular, a polystyrene resin, a polycarbonate resin, a polyester carbonate resin, and a polyester resin are preferred, and among polyester resins, a polyester resin obtained by copolymerizing polyethylene glycol, polypropylene glycol or polytetramethylene glycol each having a great effect of imparting film moldability, stretchability and flexibility is preferred.

The blending ratio of the polymer having other structures is not particularly limited, but if the amount added is too large, the optical performance of the polymer of the present invention, such as transparency and wavelength dispersibility, may be deteriorated or the optical properties of the retardation film may be changed due to environmental change. Therefore, the blending ratio is preferably 10 wt% or less, more preferably 5 wt% or less, still more preferably 3 wt% or less, based on the total of polymers.

The blending may be performed by mixing the above-described components simultaneously or in an arbitrary order by means of a mixer such as tumbler, V-blender, Nauta mixer, Banbury mixer, kneading roll and extruder, but among others, kneading by an extruder, particularly a twin-screw extruder, is preferred from the standpoint of enhancing the dispersibility.

{(ii) Method where the resin composition comprising a compound having a reactive functional group}

In the present invention, for preventing a change in optical properties of the retardation film due to an environmental change, it is also effective to add a compound having a reactive functional group, such as epoxy compound, isocyanate compound and carbodiimide compound. If the amount of such a compound added is too large, gelling may occur to cause a defect of the retardation film or involve deterioration of the optical properties. Therefore, the mixing ratio to the polymer of the present invention is from 0.01 to 5 parts by weight, preferably from 0.05 to 4 parts by weight, more preferably from 0.1 to 3 parts by weight, per 100 parts by weight of the polymer of the present invention.

The method for adding the above-described reactive functional group-containing compound to the polymer of the present invention includes a method where those compound components above are mixed simultaneously or in an arbitrary order by means of a mixer such as tumbler, V-blender, Nauta mixer, Banbury mixer, kneading roll and extruder, but among these, kneading by an extruder, particularly a twin-screw extruder, is preferred from the standpoint of enhancing the dispersibility.

The method for producing the retardation film of the present invention by using a resin composition (hereinafter, sometimes referred to as "the resin composition of the present invention") where a carbodiimide compound is added to the polymer of the present invention, is described below.

In this case, the resin composition of the present invention contains at least the polymer of the present invention, preferably the polycarbonate resin of the present invention and a carbodiimide compound.

<Carbodiimide Compound>

The carbodiimide compound for use in the present invention (hereinafter, sometimes referred to as "the carbodiimide compound of the present invention") is preferably a carbodiimide compound having one or more carbodiimide groups in the molecule (including a polycarbodiimide compound), and those synthesized by a commonly well-known method can be used. For example, a carbodiimide compound synthesized by subjecting various polyisocyanates to a decarboxylative condensation reaction in a solvent-less system or in the presence of an inert solvent at a temperature of about 70°C or more by using, as the catalyst, an organic phosphorus compound or an organic metal compound can be used.

Out of the carbodiimide compounds above, examples of the monocarbodiimide compound include dicyclohexylcarbodiimide, diisopropylcarbodiimide, dimethylcarbodiimide, diisobutylcarbodiimide, dioctylcarbodiimide, tert-butylisopropylcarbodiimide, diphenylcarbodiimide, di-tert-butylcarbodiimide, and di-β-naphthylcarbodiimide, and among these, dicyclohexylcarbodiimide and diisopropylcarbodiimide are preferred in view of industrial availability.

Also as the polycarbodiimide compound encompassed by the carbodiimide compound above, those produced by various methods may be used, but, fundamentally, a polycarbodiimide compound produced by the conventional polycarbodiimide production method (see, for example, U.S. Patent No. 2,941,956, JP-B-47-33279 (the term "JP-B" as used herein means an "examined Japanese patent publication"), J. Org. Chem. 28, 2069-2075 (1963), and Chemical Review 1981, Vol. 8, No. 4, pp. 619-621) can be used.

The organic diisocyanate as a synthesis raw material in the production of the polycarbodiimide includes, for

example, an aromatic diisocyanate, an aliphatic diisocyanate, an alicyclic diisocyanate, and a mixture thereof. Specific examples thereof include 1,5-naphthalene diisocyanate, 4,4'-diphenylmethane diisocyanate, 4,4'-diphenyldimethylmethane diisocyanate, 1,3-phenylene diisocyanate, 1,4-phenylene diisocyanate, 2,4-tolylene diisocyanate, a mixture of 2,4-tolylene diisocyanate and 2,6-tolylene diisocyanate, hexamethylene diisocyanate, cyclohexane-1,4-diisocyanate, xylylene diisocyanate, isophorone diisocyanate, dicyclohexylmethane-4,4'-diisocyanate, methylcyclohexane diisocyanate, tetramethylxylylene diisocyanate, 2,6-diisopropylphenyl diisocyanate, and 1,3,5-triisopropylbenzene 2,4-diisocyanate.

Preferred examples of the carbodiimide compound of the present invention include 4,4'-dicyclohexylmethanecarbodiimide (polymerization degree = from 2 to 20), tetramethylenexylylenecarbodiimide (polymerization degree = from 2 to 20), N,N-dimethylphenylcarbodiimide (polymerization degree: from 2 to 20), N,N'-di-2,6-diisopropylphenylcarbodiimide (polymerization degree = from 2 to 20).

One of these compounds may be used alone, or two or more thereof may be used in combination.

In the resin composition of the present invention, the content of the carbodiimide compound of the present invention is from 0.01 to 5 parts by weight, preferably from 0.05 to 4 parts by weight, more preferably from 0.1 to 3 parts by weight, per 100 parts by weight of the polymer of the present invention, such as the polycarbonate resin of the present invention. If the content of the carbodiimide compound is less than 0.01 parts by weight, when the retardation film obtained by film-forming the resin composition of the present invention is used, for example, as a retardation film for a liquid crystal display, the phase retardation greatly varies also by a long-term use under the high temperature condition, and light leakage in displaying black or color shit may be caused to deteriorate the image quality. On the other hand, if the content of the carbodiimide compound exceeds 5 parts by weight, the obtained retardation film is reduced in the transparency and when used as a retardation film, the image quality deteriorates.

<Other Additives>

In the polymer of the present invention, a heat stabilizer can be compounded so as to prevent decrease in the molecular weight or deterioration of color hue from occurring during polymerization, molding or the like.

The heat stabilizer includes a hindered phenol-based heat stabilizer and/or a phosphorus-based heat stabilizer, which are known in general.

The hindered phenol-based compound specifically includes, for example, 2,6-di-tert-butylphenol, 2,4-di-tert-butylphenol, 2-tert-butyl-4-methoxyphenol, 2-tert-butyl-4,6-dimethylphenol, 2,6-di-tert-butyl-4-methylphenol, 2,6-di-tert-butyl-4-ethylphenol, 2,5-di-tert-butylhydroquinone, n-octadecyl-3-(3',5'-di-tert-butyl-4'-hydroxyphenyl)propionate, 2-tert-butyl-6-(3'-tert-butyl-5'-methyl-2'-hydroxybenzyl)-4-methylphenyl acrylate, 2,2'-methylene-bis-(4-methyl-6-tert-butylphenol), 2,2'-methylene-bis-(6-cyclohexyl-4-methylphenol), 2,2'-ethylidene-bis-(2,4-di-tert-butylphenol), tetrakis-[methylene-3-(3',5'-di-tert-butyl-4'-hydroxyphenyl)propionate]-methane, and 1,3,5-trimethyl-2,4,6-tris-(3,5-di-tert-butyl-4-hydroxybenzyl)benzene. In particular, tetrakis-[methylene-3-(3',5'-di-tert-butyl-4'-hydroxyphenyl)propionate]-methane, n-octadecyl-3-(3',5'-di-tert-butyl-4'-hydroxyphenyl)propionate and 1,3,5-trimethyl-2,4,6-tris-(3,5-di-tert-butyl-4-hydroxybenzyl)benzene are mentioned.

The phosphorus-based compound includes, for example, a phosphorous acid, a phosphoric acid, a phosphonous acid, a phosphonic acid, and an ester thereof and specifically includes triphenyl phosphite, tris(nonylphenyl)phosphite, tris(2,4-di-tert-butylphenyl)phosphite, tridecyl phosphite, trioctyl phosphite, trioctadecyl phosphite, didecylmonophenyl phosphite, dioctylmonophenyl phosphite, diisopropylmonophenyl phosphite, monobutyldiphenyl phosphite, monodecyldiphenyl phosphite, monooctyldiphenyl phosphite, bis(2,6-di-tert-butyl-4-methylphenyl)pentaerythritol diphosphite, 2,2-methylenebis(4,6-di-tert-butylphenyl)octyl phosphite, bis(nonylphenyl)pentaerythritol diphosphite, bis(2,4-di-tert-butylphenyl)pentaerythritol diphosphite, distearyl pentaerythritol diphosphite, tributyl phosphate, triethyl phosphate, trimethyl phosphate, triphenyl phosphate, diphenylmonoorthoxenyl phosphate, dibutyl phosphate, dioctyl phosphate, diisopropyl phosphate, tetrakis(2,4-di-tert-butylphenyl) 4,4'-biphenylenediphosphinate, dimethyl benzenephosphonate, diethyl benzenephosphonate, and dipropyl benzenephosphonate.

One of these heat stabilizers may be used alone, or two or more thereof may be used in combination.

As for such a heat stabilizer, for example, in the case of forming a film by using an extruder such as melt extrusion method, the film may be formed by adding the heat stabilizer and the like to the extruder, or the heat stabilizer and the like may be previously added to the resin composition by using a stabilizer or may be added during melt polymerization. Also, the heat stabilizer may be additionally compounded by the above-described method, in addition to the amount of the heat stabilizer added during melt polymerization. That is, when the heat stabilizer is compounded after obtaining the polymer of the present invention, the heat stabilizer can be compounded in a larger amount while avoiding increase in haze, coloration and reduction in heat resistance, and the color hue can be prevented from deterioration.

The compounding amount of the heat stabilizer is preferably from 0.0001 to 1 part by weight, more preferably from 0.0005 to 0.5 parts by weight, still more preferably from 0.001 to 0.2 parts by weight, per 100 parts by weight of the polymer of the present invention such as the polycarbonate resin of the present invention.

Furthermore, in the resin composition of the present invention, a commonly known antioxidant may also be compounded for the purpose of preventing oxidation.

The antioxidant includes, for example, one member or two or more members of pentaerythritol tetrakis(3-mercaptopropionate), pentaerythritol tetrakis(3-laurylthiopropionate), glycerol-3-stearylthiopropionate, triethylene glycol-bis[3-(3-tert-butyl-5-methyl-4-hydroxyphenyl)propionate], 1,6-hexanediol-bis[3-(3,5-di-tert-butyl-4-hydroxyphenyl)propionate], pentaerythritol-tetrakis[3-(3,5-di-tert-butyl-4-hydroxyphenyl)propionate], octadecyl-3-(3,5-di-tert-butyl-4-hydroxyphenyl)propionate, 1,3,5-trimethyl-2,4,6-tris(3,5-di-tert-butyl-4-hydroxybenzyl)benzene, N,N-hexamethylenebis(3,5-di-tert-butyl-4-hydroxy-hydrocinnamide), diethyl 3,5-di-tert-butyl-4-hydroxybenzylphosphonate, tris(3,5-di-tert-butyl-4-hydroxybenzyl)isocyanurate, tetrakis(2,4-di-tert-butylphenyl) 4,4'-biphenylenediphosphinate, and 3,9-bis{1,1-dimethyl-2-[β-(3-tert-butyl-4-hydroxy-5-methylphenyl)propionyloxy]ethyl}-2,4,8,10-tetraoxaspiro(5,5)undecane.

The compounding amount of the antioxidant is preferably from 0.0001 to 0.5 parts by weight per 100 parts by weight of the polymer of the present invention such as the polycarbonate resin of the present invention.

Furthermore, as long as the object of the present invention is not impaired, the resin composition of the present invention may contain a nucleating agent, a flame retardant, an inorganic filler, an impact modifier, a foaming agent, a dye/pigment, and the like, which are employed in general.

<Production Method of Resin Composition>

The resin composition of the present invention can be produced by mixing the above-described components simultaneously or in an arbitrary order by means of a mixer such as tumbler, V-blender, Nauta mixer, Banbury mixer, kneading roll and extruder.

{(iii) Method where the conditions in the stretching step are controlled}

The method for producing the retardation film of the present invention, where an original film is obtained by a melt film formation method using the polymer of the present invention and treatment conditions when stretching the film are controlled, is described below.

The method for forming an original film by using the polymer of the present invention includes a casting method of dissolving the polymer in a solvent, casting the resulting solution and then removing the solvent; and a method of performing melt film formation without using a solvent, specifically, for example, a melt extrusion method using a T-die, a calender molding method, a hot press method, a co-extrusion method, a co-melting method, a multilayer extrusion method, and an inflation molding method. The method is not particularly limited, but since the casting method has the above-described problems attributable to the residual solvent, a melt film-forming method is preferred, and a melt extrusion method using a T-die is more preferred in view of ease of the later stretching treatment.

In the case of molding the original film by a melt film-forming method, the molding temperature is preferably 265°C or less, more preferably 260°C or less, still more preferably 258°C or less. If the molding temperature is too high, the number of defects due to generation of a foreign matter or a bubble in the original film obtained may increase or the original film may be colored. On the other hand, if the molding temperature is too low, the viscosity of the polymer of the present invention may be excessively increased, making it difficult to mold the original film and in turn, obtain an original film having a uniform thickness. Therefore, the lower limit of the molding temperature is usually 200°C or more, preferably 210°C or more, more preferably 220°C or more.

Here, the molding temperature of the original film is the temperature during molding in a melt film-forming method and usually, is a value obtained by measuring the temperature at the die outlet from which the molten resin is extruded.

The thickness of the original film is not limited, but a too large thickness may readily cause a thickness unevenness and a too small thickness may involve rupture during stretching. Therefore, the thickness is usually from 50 to 200 μm, preferably from 70 to 120 μm. Also, if the original film has a thickness unevenness, a retardation unevenness of the retardation film may be caused, and therefore, the thickness of the portion that is used as the retardation film is preferably not more than given thickness ±3 μm, more preferably not more than given thickness ±2 μm, still more preferably not more than given thickness ±1 μm.

The original film obtained in this way is stretched in at least one direction, whereby the retardation film of the present invention can be obtained.

As the method for stretching, various stretching methods such as free-end stretching, fixed-end stretching, free-end shrinkage and fixed-end shrinkage may be used individually or may be used simultaneously or successively.

The stretching direction is also not particularly limited, and stretching in various directions or dimensions such as horizontal direction, vertical direction, thickness direction and diagonal direction can be performed.

Preferred methods include a horizontal uniaxial stretching method, a vertical and horizontal simultaneous biaxial stretching method, and a vertical and horizontal sequential biaxial stretching method.

As the means for stretching, an appropriate arbitrary stretching machine such as tenter stretching machine and biaxial stretching machine can be used.

As the stretching temperature, a proper value is appropriately selected according to the purpose. Preferably, the stretching is performed at a temperature ranging from Tg-20°C to Tg+30°C, preferably from Tg-10°C to Tg+20°C, more preferably from Tg-5°C to Tg+10°C, with respect to the glass transition temperature (Tg) of the original film (that is, the polymer or resin composition as the film-forming material of the original film). By selecting such a condition, the retardation value is likely to become uniform and at the same time, clouding of the film can hardly occur. Specifically, the stretching temperature is from 90 to 210°C, preferably from 100 to 200°C, more preferably from 100 to 180°C.

The stretch ratio may be appropriately selected according to the purpose, and assuming that the stretch ratio in the unstretched state is 1 times, the stretch ratio is preferably from 1.1 to 6 times, more preferably from 1.5 to 4 times, still more preferably from 1.8 to 3 times, yet still more preferably from 2 to 2.5 times. An excessively large stretch ratio may not only involve rupture during stretching but also may reduce the effect of suppressing variation of optical properties in a long-term-use under the high temperature condition, and an excessively low stretch ratio may make it impossible to impart intended optical properties with the desired thickness.

The stretching speed is also appropriately selected according to the purpose but, in terms of the stain rate represented by the following formula, is usually from 50 to 2,000%, preferably from 100 to 1,500%, more preferably from 200 to 1,000%, still more preferably from 250 to 500%. An excessively high stretching speed may involve rupture during stretching or lead to an increase in the variation of optical properties in a long-term use under the high temperature condition. Also, an excessively low stretching speed may not only result in reducing the productivity but also may require employing an excessively large stretch ratio to obtain the desired phase retardation.

$$\text{Strain rate (\%/min)} = \{\text{stretching speed (mm/min)}/\text{length of original film (mm)}\} \times 100$$

After the stretching, a heat fixing treatment may also be performed in a heating furnace, and a relaxation step may also be performed by controlling the width of tenter or adjusting the peripheral velocity of roll.

As for the temperature at the heat fixing treatment, the treatment is performed at a temperature ranging from 60°C to Tg, preferably from 70°C to Tg-5°C, with respect to the glass transition temperature (Tg) of the original film (that is, the polymer or resin composition as the film-forming material of the original film). If the heat treatment temperature is too high, the molecular orientation obtained by stretching may be disturbed to cause a large drop from the desired phase retardation.

In the case of providing a relaxation step, the stress produced in the stretched film can be removed by causing a shrinkage of 95 to 100% based on the width of the film expanded by stretching. At this time, the treatment temperature applied to the film is the same as the heat fixing temperature.

By performing the above-described heat fixing treatment or relaxation step, the variation occurring in optical properties in a long-term use under the high temperature condition can be suppressed.

The retardation film of the present invention can be produced by appropriately selecting and adjusting the treatment conditions in such a stretching step.

<Chlorine Content in Retardation Film>

The retardation film is sometimes caused to contain chlorine depending on the production method of the polymer or the production method of the original film. In particular, when an interfacial method is employed as the production method of the polymer or a casting method is employed as the production method of the original film, the polymer and in turn, the retardation film may come to contain methylene chloride, chlorobenzene or the like in the form of a residual solvent. If the film contains a chlorine-containing solvent, the chlorine-containing component volatilizing during original film formation or stretching operation may involve corrosion of or damage to the film-forming apparatus or stretching apparatus and after the film is assembled as a retardation plate, this component may adversely affect other members. Furthermore, the solvent remaining in the retardation film plastically acts and therefore, may cause a change in optical properties due to an external environmental change such as temperature and humidity. For this reason, the chlorine content in the retardation film of the present invention is, in terms of the weight of chlorine atom, preferably 50 ppm or less, more preferably 20 ppm or less, still more preferably 10 ppm or less, yet still more preferably 5 ppm or less.

The chlorine-containing solvent is an organic solvent containing chlorine in the molecular structure and includes, for example, a chlorine-substituted hydrocarbon compound such as methylene chloride, chloroform, carbon tetrachloride, 1,1-dichloroethane, 1,2-dichloroethane, 1,1,1-trichloroethane, 1,1,2-trichloroethane, 1,1,2,2-tetrachloroethane, chlorobenzene and dichlorobenzene. Most of chlorine-containing solvents are subject to legislative regulations and therefore, the content thereof in the retardation film of the present invention is preferably smaller but is usually 50 ppm by weight

or less, preferably 20 ppm by weight or less, more preferably 10 ppm by weight or less, still more preferably 5 ppm by weight or less, yet still more preferably 1 ppm by weight or less.

The method for decreasing the residual solvent includes, for example, a method where the obtained polymer is devolatilized using an extruder, a method where the obtained polymer is depressurized or dried with hot air or hot nitrogen, a method where film formation is performed while devolatilizing the polymer by the extruder used for the original film formation, in addition to employing a melt polymerization method as the production method of the polymer.

< Content of Monohydroxy Compound >

On the other hand, when the polymer of the present invention is produced by a melt polymerization method, a by-product monohydroxy compound such as phenol may be contained in the retardation film, and similarly to the chlorine-based solvent, the monohydroxy compound also plastically acts and therefore, may cause a change in optical properties due to an external environmental change such as temperature and humidity. For this reason, the upper limit of the concentration of the monohydroxy compound in the retardation film of the present invention is usually 3,000 ppm by weight, preferably 2,000 ppm by weight, more preferably 1,500 ppm by weight, still more preferably 1,000 ppm by weight. As for the lower limit, the concentration may be preferably smaller to solve the above-described problem, but it is difficult to eliminate the monohydroxy compound remaining in the polymer obtained by a melt polymerization method to zero, and the removal requires an enormous labor. Therefore, the lower limit is usually 1 ppm by weight, preferably 10 ppm by weight, more preferably 100 ppm by weight.

The method for decreasing the monohydroxy compound remaining in the retardation film of the present invention includes, for example, a method where at the time of producing the polymer of the present invention working out to the raw material, the pressure in the final polymerization tank is reduced to 3 kPa or less, preferably 2 kPa or less, a method where the resin is fed in a molten state from the final polymerization reactor to a single- or twin-screw extruder having a single vent port or a plurality of vent ports and the monohydroxy compound is removed by reducing the pressure at the vent port, a method where film formation is performed while devolatilizing the polymer under reduced pressure by employing a structure having a vent port for the extruder used in the original film formation, and a method where after the original film formation or stretching, the film is treated in vacuum or with hot air or the like, and among others, a combination of two or more of these operations is effective. The content of the monohydroxy compound in the retardation film can be quantitatively determined by a known method such as high-performance liquid chromatography after dissolving the retardation film in a solvent.

{(iv) Method where crosslinking is formed after film formation and stretching}

Also, in the present invention, in order to constrain the movement of molecule and suppress the variation of optical properties by a long-term use under the high temperature condition, the retardation film after original film formation or after stretching may be irradiated with a high-energy ray such as electron beam to form a crosslinked structure in the molecule.

At this time, a compound having a double bond, such as divinylbenzene and allyl (meth)acrylate, or a polymer thereof can be previously compounded in the polymer of the present invention so as to facilitate the formation of a crosslinked structure, and among others, a compound having two or more double bond groups in the molecule, such as triallyl isocyanurate and diallyl monoglycidyl isocyanurate, can also be compounded. Containing such a compound makes it easy to form a crosslinked structure in the molecule by the irradiation with heat or a high-energy ray such as electron beam and constrain the movement of molecule.

The compounding amount of the compound having two or more unsaturated double bond groups in the molecule is preferably from 0.01 to 5 parts by weight, more preferably from 0.05 to 3 parts by weight, per 100 parts by weight of the polymer of the present invention.

Incidentally, in the case where the film after stretching is irradiated with an electron beam, the intensity of the electron beam is from 5 to 200 kGy, more preferably from 10 to 100 kGy. If the irradiation intensity of the electron beam is less than 5 kGy, the effect of suppressing the variation of optical properties of the retardation film in a long-term use under the high temperature condition is low, whereas if the irradiation intensity exceeds 200 kGy, breakage of the molecular chain may be involved to reduce the strength of the retardation film or cause coloration.

[Circularly Polarizing Plate and Image Display Device]

The circularly polarizing plate of the present invention is constructed by stacking the retardation film of the present invention on a polarizing plate.

As the polarizing plate, known polarizing plates of various configurations can be employed. For example, a polarizing plate prepared by a conventionally known method of adsorbing iodine or a dichroic substance such as dichroic

dye to various films, thereby dyeing the film, and then subjecting to the film to crosslinking, stretching and drying, can be used.

The image display device of the present invention utilizes such a circularly polarizing plate of the present invention and by making use of the characteristic feature that the problem of deterioration of the image quality does not occur even in a long-term use under environment of severe temperature or humidity conditions, the image display device is used in various liquid crystal display devices, mobile devices and the like and, among others, is suitably used in an organic EL display recently receiving attention as a next-generation image display device.

Examples

The present invention is described in greater detail below by referring to Examples, but the present invention is not limited to these Examples as long as the purport thereof is observed.

In the following, the characteristic evaluations of the polycarbonate resin, polycarbonate resin composition, original film and retardation film were performed by the methods described below. Incidentally, the methods for characteristic evaluations are not limited to the following methods and can be appropriately selected by one skilled in the art.

[Evaluation of Polycarbonate Resin and Polycarbonate Resin Composition]

(1) Photoelastic Coefficient

<Production of Sample>

4.0 g of a polycarbonate resin sample subjected to vacuum drying at 80°C for 5 hours was pressed for 1 minute with a hot press under the conditions of a hot press temperature of 200 to 250°C, preheating for 1 to 3 minutes and a pressure of 20 MPa by using a spacer having a width of 8 cm, a length of 8 cm and a thickness of 0.5 mm and thereafter, the pressed resin was taken out together with the spacer and pressed/cooled for 3 minutes at a pressure of 20 MPa by means of a water tube-cooled press to produce a sheet. A sample having a width of 5 mm and a length of 20 mm was cut out of the sheet.

<Measurement>

The measurement was performed using an apparatus combining a birefringence measuring apparatus composed of a He-Ne laser, a polarizer, a compensator, an analyzer and a photodetector with a vibration-type viscoelasticity measuring apparatus ("DVE-3", manufactured by Rheology) (for details, see Journal of the Society of Rheology Japan, Vol. 19, pp. 93-97 (1991)).

Each sample cut out was fixed in the viscoelasticity measuring apparatus, and the storage elastic modulus E' was measured at a room temperature of 25°C at a frequency of 96 Hz. At the same time, laser light emitted was passed through the polarizer, the sample, the compensator and the analyzer in this order and collected in the photodetector (photodiode). With respect to the waveform at an angular frequency of $\omega$ or $2\omega$, the phase retardation for the amplitude and strain was determined through a lock-in amplifier, and the strain-optical coefficient O' was determined. At this time, the directions of the polarizer and the analyzer were crossing at a right angle and each was adjusted to make an angle of $\pi/4$ with the extension direction of the sample.

The photoelastic coefficient C was determined using the storage elastic modulus E' and the strain-optical coefficient O' according to the following formula:

$$C=O'/E'$$

(2) Reduced Viscosity

The reduced viscosity of the polycarbonate resin was measured at a temperature of 20.0°C±0.1°C by using an Ubbelohde viscosity tube manufactured by Moritomo Rika Kogyo and using methylene chloride as the solvent. The concentration was precisely adjusted to 0.6 g/dL.

The relative viscosity $\eta rel$ was determined from the flow-through time t0 of solvent and the flow-through time t of solution according to the following formula:

$$\eta_{rel}=t/t_0$$

The specific viscosity ηsp was determined from the relative viscosity ηrel according to the following formula:

$$\eta_{sp}=(\eta-\eta_0)/\eta_0=\eta_{rel}-1$$

The reduced viscosity (converted viscosity) ηred was determined by dividing the specific viscosity $\eta_{sp}$ by the concentration c (g/dL) according to the following formula:

$$\eta_{red}=\eta_{sp/c}$$

A higher value indicates a larger molecular weight.

(3) Glass Transition Temperature of Polymer

As for the glass transition temperature of the polymer of the present invention, about 10 mg of the retardation film sample was heated at a temperature rise rate of 10°C/min and measured using a differential scanning calorimeter (DSC 220, manufactured by METTLER), and an extrapolation glass transition starting temperature that is a temperature at the intersection of a straight line drawn by extending the low temperature-side base line toward the high temperature side and a tangential line drawn at the point where the curve of the stepwise changing part of glass transition has a maximum gradient, was determined in accordance with JIS-K7121 (1987) and taken as the glass transition temperature.

(4) Measurement of Ratio of Structural Units Derived from Monomer Units in Polymer

As for the ratio of structural units derived from respective dihydroxy compounds in the polymer, 30 mg of the polymer was weighed and dissolved in about 0.7 mL of deuterochloroform to prepare a solution, and this solution was put in an NMR tube having an inner diameter of 5 mm and measured for the $^1$H-NMR spectrum at ordinary temperature by using JNM-AL400 (resonance frequency: 400 MHz), manufactured by JEOL Ltd. The ratio was determined from the intensity ratio of signals based on structural units derived from respective components.

(5) Measurement of Chlorine Content in Polymer

A polymer sample was precisely weighed on a quartz boat and measured by a total organic halogen analyzer, TOX-100 (manufactured by Mitsubishi Chemical Analytech Co., Ltd.). The measured value was taken as the chlorine content.

(6) Methylene Chloride Content in Polymer

The polymer was precisely weighed about 10 g, put in a heating furnace and heated at 350°C, and a nitrogen gas was flowed into the heating furnace at a flow rate of 40 mL/min. The nitrogen gas was accompanied with the gas generated by heating and introduced into an absorption tube containing 20 mL of dioxane. The absorption tube was cooled to 13°C. After flowing a nitrogen gas for 120 minutes, the absorption liquid was analyzed by gas chromatography, and the content of methylene chloride was measured. The measured value was taken as the methylene chloride content of the retardation film.

(7) Phenol Content in Polymer

A polymer sample was precisely weight about 1 g and dissolved in 5 mL of methylene chloride to prepare a solution, and a reprecipitation treatment was performed by adding acetone to make a total amount of 25 mL. The resulting solution was filtered through a 0.2 μm disc filter and quantitatively determined by liquid chromatography. The measured value was taken as the phenol content of the retardation film.

[Evaluation of Original Film and Retardation Film]

(1) Film Thickness and Thickness Unevenness

The thickness was measured using a contact-type thickness gauge, "PEACOCK" (product name), manufactured by Ozaki MFG. Co., Ltd.

(2) Melt Film Formability of Original Film

In order to evaluate the melt film formability, the following observation/evaluation was performed at the time of melt film-forming the polycarbonate resin or polycarbonate resin composition.

A: A defect was not found when the presence or absence of a foreign matter or a bubble in the film was observed with an eye.
C: A defect was found when the presence or absence of a foreign matter or a bubble in the film was observed with an eye.

(3) Phase Retardation and Birefringence

With respect to a sample cut out into a width of 4 cm and a length of 4 cm from the film obtained by melt film-forming and uniaxially stretching of the polycarbonate resin or the polycarbonate resin composition, the retardation R(450) at a wavelength of 450 nm, retardation R(550) at a wavelength of 550 nm and retardation R(650) at a wavelength of 650 nm were measured in a room at 23°C by using ["AxoScan" (product name) manufactured by Axometrics Inc.], and each of the ratio between retardation R(450) and retardation R(550), and the ratio between retardation R(650) and retardation R(550) was calculated.

As for the phase retardation, a retardation film after stretching step was measured for the retardation $R_1(450)$, retardation $R_1(550)$ and $R_1(650)$, and at the same time, measured for the retardation $R_2(450)$, retardation $R_2(550)$ and retardation $R_2(650)$ after holding at 90°C for 48 hours.

Also, the birefringence at a wavelength of 550 nm was determined by dividing the retardation $R_1(550)$ by the thickness (t) of the film obtained by uniaxial stretching according to the following formula:

$$\text{Birefringence } (\Delta n1) = R_1(550)/t$$

(4) Evaluation of Unevenness

A circularly polarizing plate was produced by laminating each of retardation films obtained in Examples and Comparative Examples and a polarizing plate (NPF TEG1465DUHC, trade name, produced by Nitto Denko Corporation, thickness excluding pressure-sensitive adhesive layer: 112 μm) through an acrylic pressure-sensitive adhesive (20 μm) such that the angle between a slow axis of the retardation film and an absorption axis of the polarizer became 45°. This circularly polarizing plate was laminated onto a viewing side of an organic EL panel (15EL9500, trade name, produced by LG Display Co., Ltd.) through the same acrylic pressure-sensitive adhesive (thickness: 20 μm) to prepare a display panel device. Incidentally, the organic EL panel employed for evaluation was used after previously peeling off the antireflection film laminated to the surface. The evaluation method was performed as follows.

The panel produced was stored in a constant-temperature oven at 90°C for 48 hours (heating test), and the screen unevenness and color tone before and after the heat treatment were confirmed with an eye.

A: Unevenness could not be confirmed on the screen when observed with an eye, and a sharp black color was obtained.
B: Unevenness could not be confirmed on the screen when observed with an eye, but sharpness of black was reduced.
BB: Sharpness of black on the screen was not reduced when observed with an eye, but unevenness was confirmed.
C: Unevenness was confirmed on the screen when observed with an eye, and sharpness of black was reduced.

(5) Glass Transition Temperature (Tg)

The original film and retardation film were measured for the glass transition temperature by the same method as that for the glass transition temperature of the polymer.

In the following Synthesis Examples, the compounds recited below were used.

ISB: Isosorbide [trade name: POLYSORB, produced by Roquette Freres]
BHEPF
9,9-Bis[4-(2-Hydroxyethoxy)phenyl]fluorene [produced by Osaka Gas Chemicals Co., Ltd.]
PEG #1000: Polyethylene glycol having a number average molecular weight of 1,000 [produced by Sanyo Chemical Industries, Ltd.]
PEG #2000: Polyethylene glycol having a number average molecular weight of 2,000 [produced by Sanyo Chemical Industries, Ltd.]
DEG: Diethylene glycol [produced by Mitsubishi Chemical Corporation]
CHDM: 1,4-Cyclohexanedimethanol [trade name: SKY CHDM, produced by New Japan Chemical Co., Ltd.]
SPG: Spiroglycol [produced by Mitsubishi Gas Chemical Company, Inc.]
DPC: Diphenyl carbonate [produced by Mitsubishi Chemical Corporation]

[Synthesis Example 1]

445.1 Parts by weight of isosorbide (hereinafter, sometimes simply referred to as "ISB"), 906.2 parts by weight of 9,9-(4-(2-hydroxyethoxy)phenyl)fluorene (hereinafter, sometimes simply referred to as "BHEPF"), 15.4 parts by weight of polyethylene glycol having a molecular weight of 1,000 (hereinafter, sometimes simply referred to as "PEG #1000"), 1,120.4 parts by weight of diphenyl carbonate (hereinafter, sometimes simply referred to as "DPC"), and 6.27 parts by weight of cesium carbonate (a 0.2 wt% aqueous solution) as a catalyst were charged into a reactor. As the first-stage process of reaction, in a nitrogen atmosphere, the heat medium temperature of the reaction vessel was set to 150°C, and the raw materials were dissolved, if desired, with stirring (about 15 minutes). Subsequently, the pressure in the reaction vessel was reduced from atmospheric pressure to 13.3 kPa, and while raising the heat medium temperature of the reaction vessel to 190°C over 1 hour, phenol generated was withdrawn out of the reaction vessel.
After holding the temperature in the reaction vessel at 190°C for 15 minutes, as the second-stage process, the pressure in the reaction vessel was set to 6.67 kPa and while raising the heat medium temperature of the reaction vessel to 230°C over 15 minutes, phenol generated was withdrawn out of reaction vessel. The stirring torque of the stirrer was increased and therefore, the temperature was raised to 250°C over 8 minutes. Furthermore, the pressure in the reaction vessel was reduced to 200 Pa or less so as to remove phenol generated. After reaching the predetermined stirring torque, the reaction was terminated. The reaction product obtained was extruded in water and then pelletized to obtain Polycarbonate Resin A composed of BHEPF/ISB/PEG #1000=40.3 mol%/59.4 mol%/0.3 mol%.

[Synthesis Example 2]

Polycarbonate Resin B composed of BHEPF/ISB/PEG #1000=36.7 mol%/63.0 mol%/0.3 mol% was obtained in the same manner as in Synthesis Example 1 except that in Synthesis Example 1, 489.7 parts by weight of ISB, 856 parts by weight of BHEPF, 16 parts by weight of PEG #1000, 1,162.2 parts by weight of DPC, and 6.5 parts by weight of an aqueous cesium carbonate solution as a catalyst were used.

[Synthesis Example 3]

Polycarbonate Resin C composed of BHEPF/ISB/PEG #1000=40.9 mol%/58.5 mol%/0.6 mol% was obtained in the same manner as in Synthesis Example 1 except that in Synthesis Example 1,432 parts by weight of ISB, 906.3 parts by weight of BHEPF, 30.3 parts by weight of PEG #1000, 1,104.1 parts by weight of DPC, and 6.2 parts by weight of an aqueous cesium carbonate solution as a catalyst were used.

[Synthesis Example 4]

Polycarbonate Resin D composed of BHEPF/ISB/PEG #2000=40.4 mol%/59.45 mol%/0.15 mol% was obtained in the same manner as in Synthesis Example 1 except that in Synthesis Example 1,444.7 parts by weight of ISB, 906.8 parts by weight of BHEPF, 15.4 parts by weight of PEG #2000, 1,118.5 parts by weight of DPC, and 6.3 parts by weight of an aqueous cesium carbonate solution as a catalyst were used.

[Synthesis Example 5]

Polycarbonate Resin E composed of BHEPF/ISB/PEG #2000=41.0 mol%/58.7 mol%/0.3 mol% was obtained in the same manner as in Synthesis Example 1 except that in Synthesis Example 1,432.4 parts by weight of ISB, 906.3

parts by weight of BHEPF, 30.2 parts by weight of PEG #2000, 1,101.4 parts by weight of DPC, and 6.2 parts by weight of an aqueous cesium carbonate solution as a catalyst were used.

[Synthesis Example 6]

Polycarbonate Resin F composed of BHEPF/ISB=41.8 mol%/58.2 mol% was obtained in the same manner as in Synthesis Example 1 except that in Synthesis Example 1, 433.4 parts by weight of ISB, 934.1 parts by weight of BHEPF, 1,113.5 parts by weight of DPC, and 6.2 parts by weight of an aqueous cesium carbonate solution as a catalyst were used. This polycarbonate resin had a high melt viscosity, and it took a long time and was difficult to remove a foreign matter and the like in the resin by melt filtration.

[Synthesis Example 7]

Polycarbonate Resin G composed of BHEPF/ISB/DEG=37.4 mol%/44.7 mol%/17.9 mol% was obtained in the same manner as in Synthesis Example 1 except that in Synthesis Example 1,357.2 parts by weight of ISB, 896.8 parts by weight of BHEPF, 103.9 parts by weight of diethylene glycol (hereinafter, sometimes simply referred to as "DEG"), 1,194.8 parts by weight of DPC, and 6.7 parts by weight of an aqueous cesium carbonate solution as a catalyst were used.

[Synthesis Example 8]

Polycarbonate Resin H composed of BHEPF/ISB/PEG #1000=43.4 mol%/55.3 mol%/1.3 mol% was obtained in the same manner as in Synthesis Example 1 except that in Synthesis Example 1, 390.9 parts by weight of ISB, 920.5 parts by weight of BHEPF, 62.9 parts by weight of PEG #1000, 1,056.8 parts by weight of DPC, and 5.9 parts by weight of an aqueous cesium carbonate solution as a catalyst were used.

[Synthesis Example 9]

397.3 Parts by weight of ISB, 960.1 parts by weight of BHEPF, 14.6 parts by weight of PEG #1000, 1,065.1 parts by weight of DPC, and $8.45\times10^{-3}$ parts by weight of magnesium acetate tetrahydrate as a catalyst were charged into a reactor. As the first-stage process of reaction, in a nitrogen atmosphere, the heat medium temperature of the reaction vessel was set to 150°C, and the raw materials were dissolved, if desired, with stirring (about 15 minutes). Subsequently, the internal temperature of the reactor was raised to 220°C and upon reaching 220°C, the pressure was reduced from atmospheric pressure to 13.3 kPa over 90 minutes. During this time, the internal temperature was kept at 220°C. Phenol generated was withdrawn out of the reaction vessel. After reaching to 13.3 kPa, as the second-stage process, the internal temperature was raised to 240°C over 15 minutes. During this time, the pressure was kept at 13.3 kPa. After the internal temperature reached 240°C, the pressure was reduced from 13.3 kPa to 200 Pa or less over 15 minutes. After reaching the predetermined stirring torque, the reaction was terminated. The reaction product obtained was extruded in water and then pelletized to obtain Polycarbonate Resin I composed of BHEPF/ISB/PEG #1000=44.5 mol%/55.2 mol%/0.3 mol%.

[Synthesis Example 10]

Polycarbonate Resin J composed of BHEPF/ISB/DEG=34.8 mol%/49.0 mol%/16.2 mol% was obtained in the same manner as in Synthesis Example 9 except that 267.4 parts by weight of ISB, 571.1 parts by weight of BHEPF, 64.3 parts by weight of DEG, 808.7 parts by weight of DPC, and $8.02\times10^{-3}$ parts by weight of magnesium acetate tetrahydrate as a catalyst were used.

[Synthesis Example 11]

Polycarbonate Resin K composed of BHEPF/ISB/CHDM=39.7 mol%/56.8 mol%/3.5 mol% was obtained in the same manner as in Synthesis Example 9 except that 288.1 parts by weight of ISB, 604.2 parts by weight of BHEPF, 17.5 parts by weight of CHDM, 750.9 parts by weight of DPC, and $2.23\times10^{-2}$ parts by weight of magnesium acetate tetrahydrate as a catalyst were used.

[Synthesis Example 12]

505.0 Parts by weight of BHEPF, 428.4 parts by weight of SPG, 559.2 parts by weight of DPC, and $9.02\text{x}10^{-2}$ parts by weight of calcium acetate monohydrate were charged into a reactor and thoroughly purged with nitrogen (oxygen

concentration: from 0.0005 to 0.001 vol%). Subsequently, heating was performed with a heating medium and when the internal temperature reached 100°C, stirring was started. The internal temperature was raised to 220°C in 40 minutes after starting the temperature rise and when the internal temperature reached 220°C, the system was controlled to hold this temperature. At the same time, pressure reduction was started, and the pressure was reduced to 13.3 kPa (absolute pressure, hereinafter the same) in 90 minutes after reaching 220°C. While keeping this pressure, the system was further held for 30 minutes. A phenol vapor occurring as a by-product along with the polymerization reaction was introduced into a reflux condenser at 100°C, a small amount of a monomer component contained in the phenol vapor was returned to the polymerization reactor, and the uncondensed phenol vapor was successively introduced into a condenser at 45°C and recovered.

After once restoring atmospheric pressure, the contents oligomerized as above were transferred to another polymerization reaction apparatus equipped with a stirring blade and a reflux condenser controlled to 100°C, and temperature rise and pressure reduction were started. An internal temperature of 260°C and a pressure of 200 Pa were reached in 50 minutes and thereafter, the pressure was reduced to 133 Pa or less over 20 minutes. Upon reaching a predetermined stirring power, the pressure was restored, and withdrawal of the contents (Polycarbonate Resin L) in a strand form was attempted, but gelling occurred and only a part of the contents could be withdrawn.

Characteristic evaluation results of Polycarbonate Resins A to L obtained in Synthesis Examples 1 to 12 are shown in Table 1.

[Table 1]

| | | | Synthesis Example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| Polycarbonate resin | | | A | B | C | D | E | F | G | H | I | J | K | L |
| Ratio of dihydroxy compound (mol%) | Compound of formula (1) | BHEPF | 40.3 | 36.7 | 40.9 | 40.4 | 41.0 | 41.8 | 37.4 | 43.4 | 44.5 | 34.8 | 39.7 | 45.0 |
| | Compound of formula (2) | ISB | 59.4 | 63.0 | 58.5 | 59.5 | 58.7 | 58.2 | 44.7 | 55.3 | 55.2 | 49.0 | 56.8 | - |
| | Compounds offormulae (3) to (6) | PEG #1000 | 0.3 | 0.3 | 0.6 | - | - | - | - | 1.3 | 0.3 | - | - | - |
| | | PEG #2000 | - | - | - | 0.2 | 0.3 | - | - | - | - | - | - | - |
| | | DEG | - | - | - | - | - | - | 17.9 | - | - | 16.2 | - | - |
| | | SPG | - | - | - | - | - | - | - | - | - | - | - | 55.0 |
| | | CHDM | - | - | - | - | - | - | - | - | - | - | 3.5 | - |
| Percentage of Dihydroxy compound (wt%) | Compound of formula (1) | BHEPF | 64.0 | 60.3 | 64.0 | 64.0 | 64.0 | 66.0 | 66.0 | 67.0 | 67.8 | 60.5 | 64.0 | 53.5 |
| | Compound of formula (2) | ISB | 35.0 | 38.5 | 33.9 | 34.9 | 34.0 | 34.0 | 26.3 | 28.4 | 31.2 | 31.5 | 33.9 | - |
| | Compounds offormulae (3) to (6) | PEG #1000 | 1.0 | 1.2 | 2.1 | - | - | - | - | 4.6 | 1.0 | - | - | - |
| | | PEG #2000 | - | - | - | 1.0 | 2.0 | - | - | - | - | - | - | - |
| | | DEG | - | - | - | - | - | - | 7.7 | - | - | 8.0 | - | - |
| | | SPG | - | - | - | - | - | - | - | - | - | - | - | 46.5 |
| | | CHDM | - | - | - | - | - | - | - | - | - | - | 2.1 | - |

(continued)

| | | Synthesis Example | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Physical properties of polycarbonate resin | Photoelastic coefficient ($\times 10^{-12}$ $Pa^{-1}$) | 28 | 28 | 29 | 29 | 30 | 30 | 29 | 30 | 27 | 27 | 29 | - |
| | Reduced viscosity (dl/g) | 0.316 | 0.322 | 0.328 | 0.315 | 0.331 | 0.351 | 0.365 | 0.382 | 0.350 | 0.425 | 0.289 | - |
| | Glass transition temperature (°C) | 147 | 145 | 145 | 143 | 137 | 151 | 122 | 129 | 145 | 128 | 148 | - |

[Example 1]

Polycarbonate Resin A obtained in Synthesis Example 1 was vacuum-dried at 80°C for 5 hours and from this polymer, an original film having a thickness of 100 μm was produced using a film-forming apparatus equipped with a single-screw extruder (manufactured by Isuzu Kakoki, screw diameter: 25 mm, preset cylinder temperature: 220°C), a T-die (width: 200 mm, preset temperature: 220°C), a chill roll (preset temperature: from 120 to 130°C), and a winder. A sample of 6 cm in width and 6 cm in length was cut out from this original film and measured for the thickness unevenness. This sample was uniaxially stretched in a stretch ratio of 1×2.0 times by using a batch-type biaxially stretching apparatus (manufactured by Toyo Seiki Co., Ltd.) at a stretching speed of 720 mm/min (strain rate: 1,200%/min) while adjusting the stretching temperature in the range of 127 to 177°C to give $R_1(550)$ of 130±20 nm, whereby a retardation film was obtained. At this time, in the direction perpendicular to the stretching direction, stretching was performed in the held state (stretch ratio: 1.0).

The obtained retardation film was evaluated, and the results are shown in Table 2.

[Example 2]

A retardation film was obtained in the same manner as in Example 1 except for using Polycarbonate Resin B obtained in Synthesis Example 2.

The obtained retardation film was evaluated, and the results are shown in Table 2.

[Example 3]

A retardation film was obtained in the same manner as in Example 1 except for using Polycarbonate Resin C obtained in Synthesis Example 3.

The obtained retardation film was evaluated, and the results are shown in Table 2.

[Example 4]

A retardation film was obtained in the same manner as in Example 1 except for using Polycarbonate Resin D obtained in Synthesis Example 4.

The obtained retardation film was evaluated, and the results are shown in Table 2.

[Example 5]

A retardation film was obtained in the same manner as in Example 1 except for using Polycarbonate Resin E obtained in Synthesis Example 5.

The obtained retardation film was evaluated, and the results are shown in Table 2.

[Example 6]

A blend of 99.5 parts by weight of Polycarbonate Resin G obtained in Synthesis Example 7 and 0.5 parts by weight of a carbodiimide compound (trade name: CARBODILITE LA-1, produced by Nisshinbo Industries, Inc.) was extruded at a resin temperature of 230°C by using a twin-screw extruder (TEX30HSS-32) manufactured by Japan Steel Works, Ltd., then cooled/solidified with water, and pelletized by a rotary cutter.

The obtained pellet was dried in the same manner as in Example 1 and then subjected to film formation and stretching by the same methods to obtain a retardation film.

The obtained retardation film was evaluated, and the results are shown in Table 2.

[Example 7]

A retardation film was obtained in the same manner as in Example 1 except for using Polycarbonate Resin F obtained in Synthesis Example 6.

The obtained retardation film was evaluated, and the results are shown in Table 2.

[Example 8]

Polycarbonate Resin I obtained in Synthesis Example 9 was vacuum-dried at 80°C for 5 hours and from this polymer, an original film having a thickness of 95 μm was produced using a film-forming apparatus equipped with a

single-screw extruder (manufactured by Isuzu Kakoki, screw diameter: 25 mm, preset cylinder temperature: 220°C), a T-die (width: 200 mm, preset temperature: 220°C), a chill roll (preset temperature: from 120 to 130°C), and a winder. A sample of 12 cm in width and 12 cm in length was cut out from this original film and measured for the thickness unevenness. This sample vacuum-dried at 100°C for 3 days to remove volatile components such as phenol contained in the original film. The thus-treated sample was uniaxially stretched in a stretch ratio of 1×2.0 times by using a batch-type biaxially stretching apparatus (manufactured by Bruckner) at a stretching speed of 360 mm/min (strain rate: 300%/min) while adjusting the stretching temperature in the range of 127 to 177°C to give $R_1(550)$ of 130±20 nm, whereby a retardation film was obtained. At this time, in the direction perpendicular to the stretching direction, stretching was performed without holding.

The obtained retardation film was evaluated, and the results are shown in Table 2.

[Example 9]

A blend of 99 parts by weight of Polycarbonate Resin I obtained in Synthesis Example 9 and 1 part by weight of a polystyrene resin (trade name: G9504, produced by PS Japan Corporation) was extruded at a resin temperature of 230°C by using a twin-screw extruder (TEX30HSS-32) having two vent ports manufactured by Japan Steel Works, Ltd. while performing devolatilization from the vent port by means of a vacuum pump, then cooled/solidified with water, and pelletized by a rotary cutter.

The obtained pellet was dried in the same manner as in Example 8 and then subjected to film formation, removal of phenol and the like through a vacuum treatment, and stretching by the same methods to obtain a retardation film. The obtained retardation film was evaluated, and the results are shown in Table 2.

[Example 10]

A blend of 99 parts by weight of Polycarbonate Resin I obtained in Synthesis Example 9 and 1 part by weight of a polycarbonate containing bisphenol A as the dihydroxy compound component (trade name: NOVAREX 7022J, produced by Mitsubishi Chemical Corporation) was extruded at a resin temperature of 230°C by using a twin-screw extruder (TEX30HSS-32) having two vent ports manufactured by Japan Steel Works, Ltd. while performing devolatilization from the vent port by means of a vacuum pump, then cooled/solidified with water, and pelletized by a rotary cutter.

The obtained pellet was dried in the same manner as in Example 8 and then subjected to film formation, removal of phenol and the like through a vacuum treatment, and stretching by the same methods to obtain a retardation film. The obtained retardation film was evaluated, and the results are shown in Table 2.

[Example 11]

A blend of 99 parts by weight of Polycarbonate Resin I obtained in Synthesis Example 9 and 1 part by weight of a polyester-based elastomer containing 1,4-butanediol, terephthalic acid and polytetramethylene glycol as constituent components (trade name: PRIMALLOY CP300H, produced by Mitsubishi Chemical Corporation) was extruded at a resin temperature of 230°C by using a twin-screw extruder (TEX30HSS-32) having two vent ports manufactured by Japan Steel Works, Ltd. while performing devolatilization from the vent port by means of a vacuum pump, then cooled/solidified with water, and pelletized by a rotary cutter.

The obtained pellet was dried in the same manner as in Example 8 and then subjected to film formation, removal of phenol and the like through a vacuum treatment, and stretching by the same methods to obtain a retardation film. The obtained retardation film was evaluated, and the results are shown in Table 3.

[Example 12]

A blend of 99 parts by weight of Polycarbonate Resin I obtained in Synthesis Example 9 and 1 part by weight of a polyester-based elastomer (trade name: ECDEL 9966, produced by EASTMAN Chemical) was extruded at a resin temperature of 230°C by using a twin-screw extruder (TEX30HSS-32) having two vent ports manufactured by Japan Steel Works, Ltd. while performing devolatilization from the vent port by means of a vacuum pump, then cooled/solidified with water, and pelletized by a rotary cutter.

The obtained pellet was dried in the same manner as in Example 8 and then subjected to film formation, removal of phenol and the like through a vacuum treatment, and stretching by the same methods to obtain a retardation film. The obtained retardation film was evaluated, and the results are shown in Table 3.

[Example 13]

A retardation film was obtained in the same manner as in Example 8 except that Polycarbonate Resin J obtained in Synthesis Example 10 was used in place of Polycarbonate Resin I to obtain an extruded film having a thickness of 103 μm. The obtained retardation film was evaluated, and the results are shown in Table 3.

[Example 14]

A retardation film was obtained in the same manner as in Example 8 except that Polycarbonate Resin K obtained in Synthesis Example 11 was used in place of Polycarbonate Resin I. The obtained retardation film was evaluated, and the results are shown in Table 3.

[Example 15]

A retardation film was obtained in the same manner as in Example 14 except that Polycarbonate Resin J obtained in Synthesis Example 10 was used and the original film was not subjected to removal of phenol through a vacuum treatment. The obtained retardation film was evaluated, and the results are shown in Table 3.

[Example 16]

A retardation film was obtained in the same manner as in Example 8 except that Polycarbonate Resin H obtained in Synthesis Example 8 was used to obtain an original film having a thickness of 92 μm. The obtained retardation film was heat-treated at a heat treatment temperature of 100°C for a heat treatment time of 1 minute. The retardation film obtained after the heat treatment was evaluated, and the results are shown in Table 3.

[Comparative Example 1]

A retardation film was obtained in the same manner as in Example 1 except that Polycarbonate Resin G obtained in Synthesis Example 7 was used in place of Polycarbonate Resin A.

The obtained retardation film was evaluated, and the results are shown in Table 3.

[Comparative Example 2]

A retardation film was obtained in the same manner as in Example 1 except that Polycarbonate Resin H obtained in Synthesis Example 8 was used in place of Polycarbonate Resin A.

The obtained retardation film was evaluated, and the results are shown in Table 3.

[Comparative Example 3]

Polycarbonate Resin J obtained in Synthesis Example 10 was dissolved in methylene chloride to produce a 15 wt% solution, and film formation was performed on a stainless steel-made plate by using a film applicator with a micrometer (SA-204, manufactured by Tester Sangyo Co,. Ltd.). The film with the stainless steel plate was put in a hot air dryer and dried at 40°C for 10 minutes and further at 80°C for 20 minutes. The film was separated from the stainless steel-made plate to obtain a cast film.

The film was uniaxially stretched in a stretch ratio of 1×2.0 times by using a batch-type biaxially stretching apparatus (manufactured by Bruckner) at a stretching speed of 360 mm/min (strain rate: 300%/min) while adjusting the stretching temperature in the range of 127 to 177°C to give $R_1(550)$ of 130±20 nm, whereby a retardation film was obtained. At this time, in the direction perpendicular to the stretching direction, stretching was performed without holding.

The obtained retardation film was evaluated, and the results are shown in Table 3.

The content of residual methylene chloride and phenol was large, the wavelength dispersibility was greatly changed after heat treatment, and unevenness or reduction in black sharpness was observed.

[Table 2]

| | | Example | | | | | | | | | |
|---|---|---|---|---|---|---|---|---|---|---|---|
| | | 1 | 2 | 3 | 4 | 5 | 6 | 7 | 8 | 9 | 10 |
| Polymer used | | A | B | C | D | E | G | F | I | I | I |
| Physical properties of original film | Thickness (μm) | 71 | 99 | 110 | 105 | 105 | 110 | 93 | 95 | 88 | 93 |
| | Melt film formability | A | A | A | A | A | A | C | A | A | A |
| | Thickness unevenness (μm) | ±1 or less | ±1 or less | ±1 or less | ±1 or less | ±1 or less | ±1 or less | ±3 | ±1 or less | ±1 or less | ±1 or less |
| Physical properties of retardation film | Thickness (μm) | 50 | 70 | 78 | 74 | 74 | 78 | 66 | 67 | 62 | 66 |
| | $R_1(450)$ (nm) | 123.5 | 136.6 | 126.5 | 130.9 | 129.9 | 129.0 | 130.2 | 123.6 | 118.8 | 120.7 |
| | $R_1(550)$ (nm) | 135.7 | 146.0 | 139.8 | 144.1 | 143.2 | 141.2 | 143.2 | 140.0 | 134.5 | 134.5 |
| | $R_1(650)$ (nm) | 140.1 | 149.1 | 144.2 | 149.1 | 147.8 | 145.5 | 148.9 | 145.8 | 140.1 | 139.1 |
| | $R_1(450)/R_1(550)$ | 0.910 | 0.936 | 0.905 | 0.908 | 0.907 | 0.913 | 0.909 | 0.883 | 0.883 | 0.898 |
| | $R_1(650)/R_1(550)$ | 1.032 | 1.021 | 1.032 | 1.035 | 1.032 | 1.030 | 1.040 | 1.042 | 1.041 | 1.035 |
| | $R_2(450)$ (nm) | 130.7 | 143.0 | 135.2 | 139.1 | 138.3 | 137.8 | 138.2 | 131.6 | 125.6 | 129.2 |
| | $R_2(550)$ (nm) | 142.7 | 152.1 | 147.9 | 152.0 | 151.0 | 148.4 | 150.4 | 147.7 | 140.8 | 142.1 |
| | $R_2(650)$ (nm) | 146.3 | 154.7 | 151.9 | 157.3 | 154.9 | 152.5 | 155.4 | 153.2 | 146.2 | 146.5 |
| | $R_2(450)/R_2(550)$ | 0.916 | 0.940 | 0.914 | 0.915 | 0.916 | 0.929 | 0.919 | 0.891 | 0.892 | 0.909 |
| | $R_2(650)/R_2(550)$ | 1.025 | 1.017 | 1.027 | 1.035 | 1.026 | 1.028 | 1.033 | 1.037 | 1.038 | 1.031 |
| | $\|R_2(450)/R_2(550)-R_1(450)/R_1(550)\|$ | 0.006 | 0.005 | 0.009 | 0.007 | 0.009 | 0.016 | 0.010 | 0.009 | 0.008 | 0.011 |
| | $\|R_2(650)/R_2(550)-R_1(650)/R_1(550)\|$ | 0.007 | 0.004 | 0.005 | 0.008 | 0.006 | 0.002 | 0.007 | 0.005 | 0.004 | 0.004 |
| | Birefringence at wavelength of 550 nm | 0.0027 | 0.0021 | 0.0018 | 0.0019 | 0.0019 | 0.0018 | 0.0022 | 0.0021 | 0.0022 | 0.0020 |
| | Glass transition temperature (°C) | 147 | 145 | 145 | 143 | 137 | 120 | 151 | 145 | 145 | 145 |
| | Chlorine content (ppm by weight) | <1 | <1 | <1 | <1 | <1 | <1 | <1 | <1 | <1 | <1 |

(continued)

| | | Example | | | | | | | | | |
|---|---|---|---|---|---|---|---|---|---|---|---|
| | | 1 | 2 | 3 | 4 | 5 | 6 | 7 | 8 | 9 | 10 |
| | Methylene chloride content (ppm by weight) | <1 | <1 | <1 | <1 | <1 | <1 | <1 | <1 | <1 | <1 |
| | Phenol content (ppm by weight) | 1558 | 1447 | 1845 | 1589 | 1677 | 1757 | 1718 | 858 | 750 | 746 |
| | Unevenness | A | B | A | A | A | BB | A | A | A | A |

[Table 3]

| | | Example | | | | | | Comparative Example | | |
|---|---|---|---|---|---|---|---|---|---|---|
| | | 11 | 12 | 13 | 14 | 15 | 16 | 1 | 2 | 3 |
| Polymer used | | I | I | J | K | J | H | G | H | J |
| Physical properties of original film | Thickness (μm) | 92 | 88 | 103 | 100 | 98 | 92 | 110 | 92 | 106 |
| | Melt film formability | A | A | A | A | A | A | A | A | - |
| | Thickness unevenness (μm) | ±1 or less | ±1 or less | ±1 or less | ±1 or less | ±1 or less | ±1 or less | ±1 or less | ±1 or less | ±3 |
| Physical properties of retardation film | Thickness (μm) | 65 | 62 | 73 | 71 | 69 | 65 | 78 | 65 | 75 |
| | $R_1(450)$ (nm) | 126.0 | 122.4 | 132.6 | 130.2 | 125.0 | 109.6 | 117.6 | 109.6 | 131.5 |
| | $R_1(550)$ (nm) | 140.7 | 136.3 | 145.5 | 143.2 | 137.3 | 124.4 | 131.1 | 124.4 | 145.0 |
| | $R_1(650)$ (nm) | 145.6 | 141.1 | 150.0 | 147.7 | 141.7 | 129.6 | 136.0 | 175.3 | 148.6 |
| | $R_1(450)/R_1(550)$ | 0.896 | 0.898 | 0.911 | 0.909 | 0.910 | 0.881 | 0.897 | 0.881 | 0.907 |
| | $R_1(650)/R_1(550)$ | 1.035 | 1.035 | 1.031 | 1.031 | 1.032 | 1.041 | 1.037 | 1.409 | 1.025 |
| | $R_2(450)$ (nm) | 133.8 | 129.3 | 144.9 | 138.2 | 148.5 | 119.2 | 131.9 | 119.8 | 150.1 |
| | $R_2(550)$ (nm) | 148.0 | 142.9 | 156.9 | 150.4 | 159.9 | 133.0 | 143.6 | 133.0 | 161.2 |
| | $R_2(650)$ (nm) | 152.7 | 147.5 | 161.0 | 154.6 | 164.1 | 138.0 | 147.6 | 137.4 | 163.4 |
| | $R_2(450)/R_2(550)$ | 0.904 | 0.904 | 0.924 | 0.919 | 0.929 | 0.896 | 0.919 | 0.901 | 0.931 |
| | $R_2(650)/R_2(550)$ | 1.032 | 1.032 | 1.026 | 1.027 | 1.026 | 1.037 | 1.028 | 1.033 | 1.014 |
| | $\|R_2(450)/R_2(550)-R_1(450)/R_1(550)\|$ | 0.008 | 0.007 | 0.013 | 0.010 | 0.018 | 0.015 | 0.022 | 0.021 | 0.024 |
| | $\|R_2(650)/R_2(550)-R_1(650)/R_1(550)\|$ | 0.004 | 0.003 | 0.005 | 0.004 | 0.006 | 0.004 | 0.008 | 0.008 | 0.011 |
| | Birefringence at wavelength of 550 nm | 0.0022 | 0.0022 | 0.0020 | 0.0020 | 0.0020 | 0.0019 | 0.0017 | 0.0019 | 0.0019 |
| | Glass transition temperature (°C) | 144 | 144 | 128 | 148 | 128 | 129 | 122 | 129 | 128 |
| | Chlorine content (ppm by weight) | <1 | <1 | <1 | <1 | <1 | <1 | <1 | <1 | 209 |

(continued)

| | | Example | | | | | | Comparative Example | | |
|---|---|---|---|---|---|---|---|---|---|---|
| | | 11 | 12 | 13 | 14 | 15 | 16 | 1 | 2 | 3 |
| Polymer used | | I | I | J | K | J | H | G | H | J |
| | Methylene chloride content (ppm by weight) | <1 | <1 | <1 | <1 | <1 | <1 | <1 | <1 | 250 |
| | Phenol content (ppm by weight) | 785 | 792 | 770 | 1055 | 1640 | 937 | 995 | 937 | 2011 |
| | Unevenness | A | A | A | A | A | A | C | C | C |

It is seen from Tables 2 and 3 that the retardation film specified in the present invention undergoes little variation in the phase retardation even by a long-term use under the high temperature condition, exhibits excellent stability against temperature, is free of unevenness of image, and enables obtaining a sharp black color.

## Claims

1. A method for producing a retardation film satisfying the relationships of the following formulae (A) and (B):

$$\text{Formula (A): } 0.7 < R_1(450)/R_1(550) < 1$$

$$\text{Formula (B): } |R_2(450)/R_2(550) - R_1(450)/R_1(550)| < 0.020$$

(wherein $R_1(450)$ and $R_1(550)$ represent the retardation value in film plane at respective wavelengths of 450 nm and 550 nm, and $R_2(450)$ and $R_2(550)$ represent the retardation value in film plane at respective wavelengths of 450 nm and 550 nm after leaving the film to stand at a temperature of 90°C for 48 hours),
the method comprising subjecting a film which is stretched in a least one direction to a heat fixing treatment and/or a relaxation step.

2. The method according to claim 1, wherein the retardation film satisfies the relationships of the following formulae (C) and (D):

$$\text{Formula (C): } 1 < R_1(650)/R_1(550) < 1.2$$

$$\text{Formula (D): } |R_2(650)/R_2(550) - R_1(650)/R_1(550)| < 0.010$$

(wherein $R_1(650)$ represents the retardation value in film plane at a wavelength of 650 nm, and $R_2(650)$ represents the retardation value in film plane at a wavelength of 650 nm after leaving the film to stand at a temperature of 90°C for 48 hours).

3. The method according to claim 1 or 2, wherein the retardation film is obtained by forming a polymer containing (a) a structural unit having a positive refractive index anisotropy with the absorption end being less than 260 nm and (b) a structural unit having a negative refractive index anisotropy with the absorption end being from 260 to 380 nm.

4. The method according to claim 3, wherein said polymer is a polycarbonate resin and/or a polyester carbonate resin.

5. The method according to claim 4, wherein:

said polymer is a polycarbonate resin,
said structural unit (b) is a structural unit derived from a dihydroxy compound represented by the following formula (1), and
said structural unit (a) is a structural unit derived from a dihydroxy compound represented by the following formula (2) and structural units derived from one or more dihydroxy compounds selected from the group consisting of a dihydroxy compound represented by the following formula (3), a dihydroxy compound represented by the following formula (4), a dihydroxy compound represented by the following formula (5) and a dihydroxy compound represented by the following formula (6):

[Chem. 1]

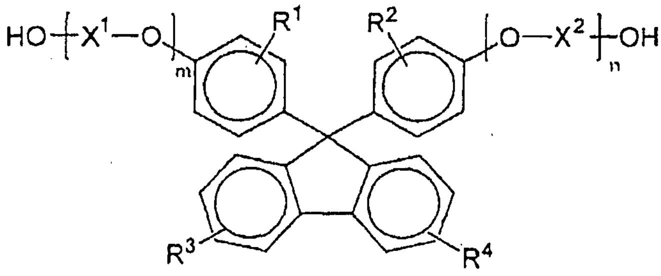

(1)

(wherein each of $R^1$ to $R^4$ independently represents a hydrogen atom, a substituted or unsubstituted alkyl group having a carbon number of 1 to 20, a substituted or unsubstituted cycloalkyl group having a carbon number of 6 to 20, or a substituted or unsubstituted aryl group having a carbon number of 6 to 20, and the same or different groups are substituted as respective substituents on four benzene rings; each of $X^1$ and $X^2$ independently represents a substituted or unsubstituted alkylene group having a carbon number of 2 to 10, a substituted or unsubstituted cycloalkylene group having a carbon number of 6 to 20, or a substituted or unsubstituted arylene group having a carbon number of 6 to 20; and each of m and n independently represents an integer of 0 to 5);

[Chem. 2]

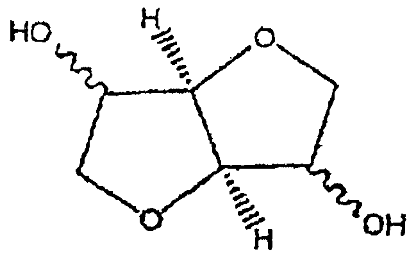

(2)

$HO\text{-}R^5\text{-}OH$ (3)

(wherein $R^5$ represents a substituted or unsubstituted cycloalkylene group having a carbon number of 4 to 20);

$HO\text{-}CH_2\text{-}R^6\text{-}CH_2\text{-}OH$ (4)

(wherein $R^6$ represents a substituted or unsubstituted cycloalkylene group having a carbon number of 4 to 20);

$H\text{-}(O\text{-}R^7)_p\text{-}OH$ (5)

(wherein $R^7$ represents a substituted or unsubstituted alkylene group having a carbon number of 2 to 10, and p represents an integer of 2 to 50); and

$HO\text{-}R^8\text{-}OH$ (6)

(wherein $R^8$ represents a substituted or unsubstituted alkylene group having a carbon number of 2 to 20, or a group represented by the following formula (6A)):

[Chem. 3]

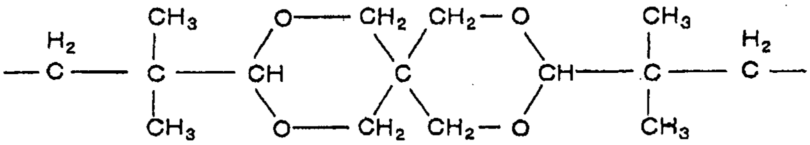

(6A)

6. The method according to claim 5, wherein in said polymer, the content of the structural unit derived from a dihydroxy compound having an acetal structure is 10 mol% or less based on all dihydroxy compound-derived structural units.

7. The method according to claim 5 or 6, wherein:

said structural unit (b) is a structural unit derived from said dihydroxy compound represented by formula (1), and said structural unit (a) is a structural unit derived from said dihydroxy compound represented by formula (2) and a structural unit derived from said dihydroxy compound represented by formula (5).

8. A retardation film satisfying the relationships of the following formulae (A) and (B):

$$\text{Formula (A): } 0.7<R_1(450)/R_1(550)<1$$

$$\text{Formula (B): } |R_2(450)/R_2(550)-R_1(450)/R_1(550)|<0.020$$

(wherein $R_1(450)$ and $R_1(550)$ represent the retardation value in film plane at respective wavelengths of 450 nm and 550 nm, and $R_2(450)$ and $R_2(550)$ represent the retardation value in film plane at respective wavelengths of 450 nm and 550 nm after leaving the film to stand at a temperature of 90°C for 48 hours) and further satisfying the relationships of the following formulae (C) and (D):

$$\text{Formula (C): } 1<R_1(650)/R_1(550)<1.2$$

$$\text{Formula (D): } |R_2(650)/R_2(550)-R_1(650)/R_1(550)|<0.010$$

(wherein $R_1(650)$ represents the retardation value in film plane at a wavelength of 650 nm, and $R_2(650)$ represents the retardation value in film plane at a wavelength of 650 nm after leaving the film to stand at a temperature of 90°C for 48 hours), which is a retardation film obtained by forming a polymer containing (a) a structural unit having a positive refractive index anisotropy with the absorption end being less than 260 nm and (b) a structural unit having a negative refractive index anisotropy with the absorption end being from 260 to 380 nm, wherein:

said polymer is a polycarbonate resin,
said structural unit (b) is a structural unit derived from a dihydroxy compound represented by the following formula (1), and
said structural unit (a) is a structural unit derived from a dihydroxy compound represented by the following formula (2) and structural units derived from one or more dihydroxy compounds selected from the group consisting of a dihydroxy compound represented by the following formula (3), a dihydroxy compound represented by the following formula (4), a dihydroxy compound represented by the following formula (5) and a dihydroxy compound represented by the following formula (6):

[Chem. 1]

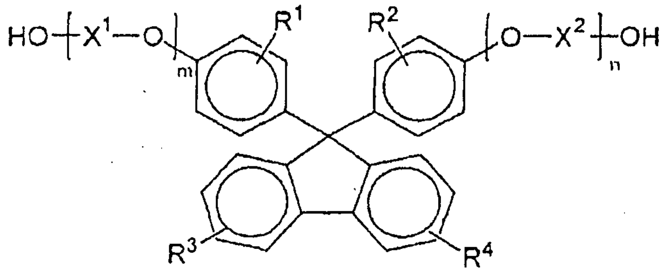

(1)

(wherein each of $R^1$ to $R^4$ independently represents a hydrogen atom, a substituted or unsubstituted alkyl group having a carbon number of 1 to 20, a substituted or unsubstituted cycloalkyl group having a carbon number of 6 to 20, or a substituted or unsubstituted aryl group having a carbon number of 6 to 20, and the same or different groups are substituted as respective substituents on four benzene rings; each of $X^1$ and $X^2$ independently represents a substituted or unsubstituted alkylene group having a carbon number of 2 to 10, a substituted or unsubstituted cycloalkylene group having a carbon number of 6 to 20, or a substituted or unsubstituted arylene group having a carbon number of 6 to 20; and each of m and n independently represents an integer of 0 to 5);

[Chem. 2]

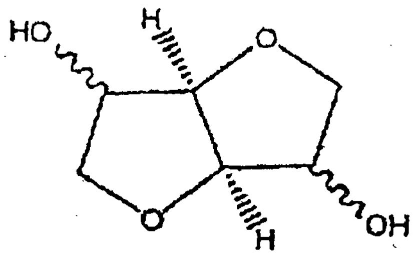

(2)

$HO\text{-}R^5\text{-}OH$ (3)

(wherein $R^5$ represents a substituted or unsubstituted cycloalkylene group having a carbon number of 4 to 20);

$HO\text{-}CH_2\text{-}R^6\text{-}CH_2\text{-}OH$ (4)

(wherein $R^6$ represents a substituted or unsubstituted cycloalkylene group having a carbon number of 4 to 20);

$H\text{-}(O\text{-}R^7)_p\text{-}OH$ (5)

(wherein $R^7$ represents a substituted or unsubstituted alkylene group having a carbon number of 2 to 10, and p represents an integer of 2 to 50); and

$HO\text{-}R^8\text{-}OH$ (6)

(wherein $R^8$ represents a substituted or unsubstituted alkylene group having a carbon number of 2 to 20, or a group represented by the following formula (6A)):

[Chem. 3]

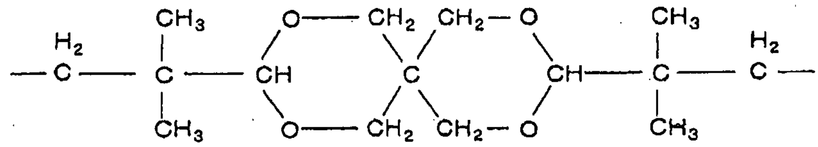

(6A)

9. The retardation film according to claim 8, wherein in said polymer, the content of the structural unit derived from a dihydroxy compound having an acetal structure is 10 mol% or less based on all dihydroxy compound-derived structural units.

10. The retardation film according to claim 8 or 9, wherein:

said structural unit (b) is a structural unit derived from said dihydroxy compound represented by formula (1), and said structural unit (a) is a structural unit derived from said dihydroxy compound represented by formula (2) and a structural unit derived from said dihydroxy compound represented by formula (5).

11. The retardation film according to any one of claims 8 to 10, which is a single-layer film.

12. The retardation film according to any one of claims 8 to 11, wherein the photoelastic coefficient of said polymer is $45\times10^{-12}$ $Pa^{-1}$ or less.

13. The retardation film according to any one of claims 8 to 12, wherein the glass transition temperature is from 110 to 150°C.

14. A circularly polarizing plate fabricated by stacking the retardation film according to any one of claims 8 to 13 and a polarizing plate.

15. An image display device having the circularly polarizing plate according to claim 14.

16. The image display device according to claim 15, wherein said image display device uses an organic EL.

**Patentansprüche**

1. Ein Verfahren zur Herstellung einer Verzögerungsfolie, welche die Beziehungen der folgenden Formeln (A) und (B) erfüllt:

$$\text{Formel (A): } 0{,}7<R_1(450)/R_1(550)<1$$

$$\text{Formel (B): } |R_2(450)/R_2(550)-R_1(450)/R_1(550)|<0{,}020$$

(wobei $R_1(450)$ und $R_1(550)$ jeweils den Verzögerungswert in der Folienebene bei Wellenlängen von 450 nm bzw. 550 nm darstellen, und $R_2(450)$ und $R_2(550)$ den Verzögerungswert in der Folienebene bei Wellenlängen von 450 nm bzw. 550 nm darstellen, nachdem die Folie bei einer Temperatur von 90°C für 48 Stunden stehen gelassen wurde), wobei das Verfahren das Aussetzen einer Folie, welche in mindestens eine Richtung gereckt wurde, einer Wärmefixierbehandlung und/oder einem Entspannungschritt umfasst.

2. Das Verfahren gemäß Anspruch 1, wobei die Verzögerungsfolie die Beziehungen der folgenden Formeln (C) und (D) erfüllt:

$$\text{Formel (C): } 1<R_1(650)/R_1(550)<1{,}2$$

$$\text{Formel (D): } |R_2(650)/R_2(550)-R_1(650)/R_1(550)|<0{,}010$$

(wobei $R_1(650)$ den Verzögerungswert in der Folienebene bei einer Wellenlänge von 650 nm darstellt, und $R_2(650)$ den Verzögerungswert in der Folienebene bei einer Wellenlänge von 650 nm darstellt, nachdem die Folie bei einer Temperatur von 90°C für 48 Stunden stehen gelassen wurde).

**3.** Das Verfahren gemäß Anspruch 1 oder 2, wobei die Verzögerungsfolie durch das Bilden eines Polymers, welches (a) eine Struktureinheit mit einer positiven Brechungsindexanisotropie aufweist, wobei das Absorptionsende weniger als 260 nm beträgt, und (b) eine Struktureinheit mit einer negativen Brechungsindexanisotropie aufweist, wobei das Absorptionsende 260 bis 380 nm beträgt, enthält.

**4.** Das Verfahren gemäß Anspruch 3, wobei das Polymer ein Polycarbonatharz und/oder ein Polyestercarbonatharz ist.

**5.** Das Verfahren gemäß Anspruch 4, wobei:

das Polymer ein Polycarbonatharz ist,
wobei die Struktureinheit (b) eine Struktureinheit ist, welche aus einer Dihydroxyverbindung, dargestellt durch die folgende Formel (1), abgeleitet ist, und
die Struktureinheit (a) eine Struktureinheit ist, welche aus einer Dihydroxyverbindung, dargestellt durch die folgende Formel (2), und Struktureinheiten, abgeleitet von einer oder mehreren Dihydroxyverbindungen, ausgewählt aus der Gruppe bestehend aus einer Dihydroxyverbindung, dargestellt durch die folgende Formel (3), einer Dihydroxyverbindung, dargestellt durch die folgende Formel (4), einer Dihydroxyverbindung, dargestellt durch die folgende Formel (5) und einer Dihydroxyverbindung, dargestellt durch die folgende Formel (6), abgeleitet ist:

[Chem. 1]

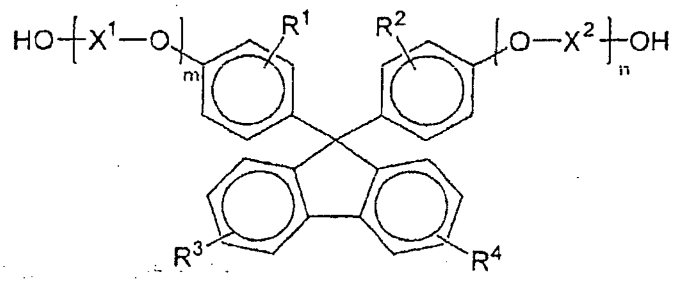

(1)

(wobei jedes von $R^1$ bis $R^4$ unabhängig ein Wasserstoffatom, eine substituierte oder unsubstituierte Alkylgruppe mit einer Kohlenstoffanzahl von 1 bis 20, eine substituierte oder unsubstituierte Cycloalkylgruppe mit einer Kohlenstoffanzahl von 6 bis 20 oder eine substituierte oder unsubstituierte Arylgruppe mit einer Kohlenstoffanzahl von 6 bis 20 darstellt, und die gleichen oder unterschiedlichen Gruppen als jeweilige Substituenten an vier Benzolringen substituiert sind; jedes von $X^1$ und $X^2$ unabhängig eine substituierte oder unsubstituierte Alkylengruppe mit einer Kohlenstoffanzahl von 2 bis 10, eine substituierte oder unsubstituierte Cycloalkylengruppe mit einer Kohlenstoffanzahl von 6 bis 20 oder eine substituierte oder unsubstituierte Arylengruppe mit einer Kohlenstoffanzahl von 6 bis 20 darstellt; und jedes von m und n unabhängig eine ganze Zahl von 0 bis 5 darstellt);

[Chem. 2]

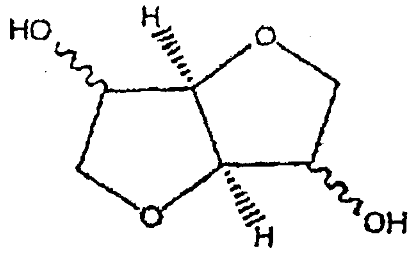

(2)

$$HO\text{-}R^5\text{-}OH \quad (3)$$

(wobei $R^5$ eine substituierte oder unsubstituierte Cycloalkylengruppe mit einer Kohlenstoffanzahl von 4 bis 20 darstellt);

$$HO\text{-}CH_2\text{-}R^6\text{-}CH_2\text{-}OH \quad (4)$$

(wobei $R^6$ eine substituierte oder unsubstituierte Cycloalkylengruppe mit einer Kohlenstoffanzahl von 4 bis 20 darstellt);

$$H\text{-}(O\text{-}R^7)_p\text{-}OH \quad (5)$$

(wobei $R^7$eine substituierte oder unsubstituierte Alkylengruppe mit einer Kohlenstoffanzahl von 2 bis 10 darstellt und p eine ganze Zahl von 2 bis 50 darstellt); und

$$HO\text{-}R^8\text{-}OH \quad (6)$$

(wobei $R^8$ eine substituierte oder unsubstituierte Alkylengruppe mit einer Kohlenstoffanzahl von 2 bis 20 oder eine Gruppe, dargestellt durch die folgende Formel (6A), darstellt):

[Chem. 3]

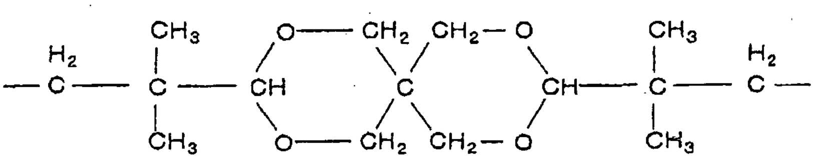

(6A)

**6.** Das Verfahren gemäß Anspruch 5, wobei in dem Polymer der Gehalt der Struktureinheit, welche von einer Dihydroxyverbindung mit einer Acetalstruktur abgeleitet ist, 10 Mol-% oder weniger beträgt, bezogen auf alle von Dihydroxyverbindungen abgeleiteten Struktureinheiten.

**7.** Das Verfahren gemäß Anspruch 5 oder 6, wobei:

die Struktureinheit (b) eine Struktureinheit ist, welche aus einer Dihydroxyverbindung, dargestellt durch die Formel (1), abgeleitet ist, und
die Struktureinheit (a) eine Struktureinheit, welche aus der Dihydroxyverbindung, dargestellt durch Formel (2), abgeleitet ist, und eine Struktureinheit, welche aus der Dihydroxyverbindung, dargestellt durch Formel (5), abgeleitet ist, ist.

**8.** Eine Verzögerungsfolie, welche die Beziehungen der folgenden Formeln (A) und (B) erfüllt:

$$\text{Formel (A): } 0{,}7<R_1(450)/R_1(550)<1$$

$$\text{Formel (B): } |R_2(450)/R_2(550)-R_1(450)/R_1(550)|<0{,}020$$

(wobei $R_1(450)$ und $R_1(550)$ jeweils den Verzögerungswert in der Folienebene bei Wellenlängen von 450 nm bzw. 550 nm darstellen, und $R_2(450)$ und $R_2(550)$ den Verzögerungswert in der Folienebene bei Wellenlängen von 450 nm bzw. 550 nm darstellen, nachdem die Folie bei einer Temperatur von 90°C für 48 Stunden stehen gelassen wurde) und ferner die Beziehungen der folgenden Formeln (C) und (D) erfüllt:

$$\text{Formel (C): } 1<R_1(650)/R_1(550)<1{,}2$$

$$\text{Formel (D): } |R_2(650)/R_2(550)-R_1(650)/R_1(550)|<0{,}010$$

(wobei $R_1(650)$ den Verzögerungswert in der Folienebene bei einer Wellenlänge von 650 nm darstellt und $R_2(650)$ den Verzögerungswert in der Folienebene bei einer Wellenlänge von 650 nm darstellt, nachdem die Folie bei einer Temperatur von 90°C für 48 Stunden stehen gelassen wurde), welche eine Verzögerungsfolie ist, die durch Bilden eines Polymers, welches (a) eine Struktureinheit mit einer positiven Brechungsindexanisotropie aufweist, wobei das Absorptionsende weniger als 260 nm beträgt, und (b) eine Struktureinheit mit einer negativen Brechungsindexanisotropie aufweist, wobei das Absorptionsende 260 bis 380 nm beträgt, enthält, wobei das Polymer ein Polycarbonatharz ist,
wobei die Struktureinheit (b) eine Struktureinheit ist, welche aus einer Dihydroxyverbindung, dargestellt durch die folgende Formel (1), abgeleitet ist, und
die Struktureinheit (a) eine Struktureinheit ist, welche aus einer Dihydroxyverbindung, dargestellt durch die folgende Formel (2), und Struktureinheiten, abgeleitet von einer oder mehreren Dihydroxyverbindungen, ausgewählt aus der Gruppe, bestehend aus einer Dihydroxyverbindung, dargestellt durch die folgende Formel (3), einer Dihydroxyverbindung, dargestellt durch die folgende Formel (4), einer Dihydroxyverbindung, dargestellt durch die folgende Formel (5), und einer Dihydroxyverbindung, dargestellt durch die folgende Formel (6), abgeleitet ist:

[Chem. 1]

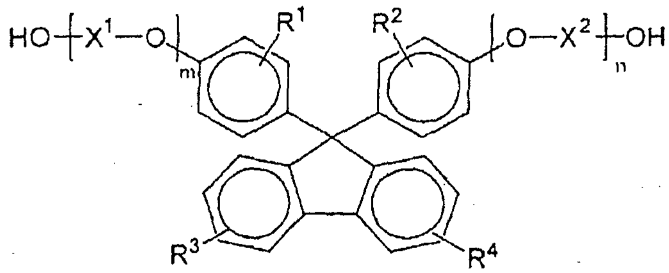

(1)

(wobei jedes von $R^1$ bis $R^4$ unabhängig ein Wasserstoffatom, eine substituierte oder unsubstituierte Alkylgruppe mit einer Kohlenstoffanzahl von 1 bis 20, eine substituierte oder unsubstituierte Cycloalkylgruppe mit einer Kohlenstoffanzahl von 6 bis 20 oder eine substituierte oder unsubstituierte Arylgruppe mit einer Kohlenstoffanzahl von 6 bis 20 darstellt, und die gleichen oder unterschiedlichen Gruppen als jeweilige Substituenten an vier Benzolringen substituiert sind; jedes von $X^1$ und $X^2$ unabhängig eine substituierte oder unsubstituierte Alkylengruppe mit einer Kohlenstoffanzahl von 2 bis 10, eine substituierte oder unsubstituierte Cycloalkylengruppe mit einer Kohlenstoffanzahl von 6 bis 20 oder eine substituierte oder unsubstituierte Arylengruppe mit einer Kohlenstoffanzahl von 6 bis 20 darstellt; und jedes von m und n unabhängig eine ganze Zahl von 0 bis 5 darstellt);

[Chem. 2]

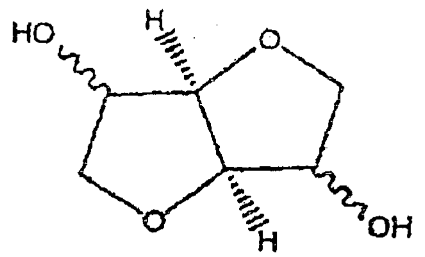

(2)

$$HO\text{-}R^5\text{-}OH \qquad (3)$$

(wobei $R^5$ eine substituierte oder unsubstituierte Cycloalkylengruppe mit einer Kohlenstoffanzahl von 4 bis 20 darstellt);

$$HO\text{-}CH_2\text{-}R^6\text{-}CH_2\text{-}OH \qquad (4)$$

(wobei $R^6$ eine substituierte oder unsubstituierte Cycloalkylengruppe mit einer Kohlenstoffanzahl von 4 bis 20 darstellt);

$$H\text{-}(O\text{-}R^7)_p\text{-}OH \qquad (5)$$

(wobei $R^7$ eine substituierte oder unsubstituierte Alkylengruppe mit einer Kohlenstoffanzahl von 2 bis 10 darstellt und p eine ganze Zahl von 2 bis 50 darstellt); und

$$HO\text{-}R^8\text{-}OH \qquad (6)$$

(wobei $R^8$ eine substituierte oder unsubstituierte Alkylengruppe mit einer Kohlenstoffanzahl von 2 bis 20 oder eine Gruppe, dargestellt durch die folgende Formel (6A), darstellt):

[Chem. 3]

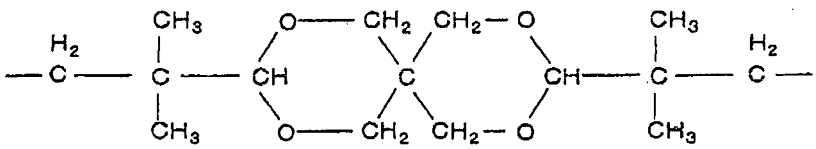

(6A)

**9.** Die Verzögerungsfolie gemäß Anspruch 8, wobei in dem Polymer der Gehalt der Struktureinheit, welche von einer Dihydroxyverbindung mit einer Acetalstruktur abgeleitet ist, 10 Mol-% oder weniger beträgt, bezogen auf alle von einer Dihydroxyverbindung abgeleiteten Struktureinheiten.

**10.** Die Verzögerungsfolie gemäß Anspruch 8 oder 9, wobei:

die Struktureinheit (b) eine Struktureinheit ist, welche aus der Dihydroxyverbindung, dargestellt durch die Formel (1), abgeleitet ist, und
die Struktureinheit (a) eine Struktureinheit, welche aus der Dihydroxyverbindung, dargestellt durch Formel (2), abgeleitet ist, und eine Struktureinheit, welche aus der Dihydroxyverbindung, dargestellt durch Formel (5), abgeleitet ist, ist.

**11.** Die Verzögerungsfolie gemäß einem der Ansprüche 8 bis 10, welche eine einschichtige Folie ist.

**12.** Die Verzögerungsfolie gemäß einem der Ansprüche 8 bis 11, wobei der photoelastische Koeffizient des Polymers $45 \times 10^{-12}\ Pa^{-1}$ oder weniger beträgt.

13. Die Verzögerungsfolie gemäß einem der Ansprüche 8 bis 12, wobei die Glasübergangstemperatur 110 bis 150°C beträgt.

14. Eine zirkulär polarisierende Platte, hergestellt durch Aufeinanderschichten der Verzögerungsfolie gemäß einem der Ansprüche 8 bis 13 und einer polarisierenden Platte.

15. Eine Bildanzeigevorrichtung mit einer zirkulär polarisierenden Platte gemäß Anspruch 14.

16. Die Bildanzeigevorrichtung gemäß Anspruch 15, wobei die Bildanzeigevorrichtung eine organische EL verwendet.

**Revendications**

1. Procédé de production d'un film de retard satisfaisant les relations des formules (A) et (B) suivantes :

$$\text{Formule (A)} : 0.7 < R_1(450)/R_1(550)<1$$

$$\text{Formule (B)} : |R_2(450)/R_2(550)-R_1(450)/R_1(550)|<0.020$$

(où $R_1(450)$ et $R_1(550)$ représentent la valeur de retard dans un plan de film aux longueurs d'ondes respectives de 450 nm et 550 nm, et $R_2(450)$ et $R_2(550)$ représentent la valeur de retard dans un plan de film aux longueurs d'ondes respectives de 450 nm et 550 nm après avoir laissé le film reposer à une température de 90°C pendant 48 heures), le procédé consistant à soumettre un film qui est étiré dans au moins une direction à un traitement de fixation à la chaleur et/ou à une étape de relaxation.

2. Procédé selon la revendication 1, dans lequel le film de retard satisfait les relations des formules (C) et (D) suivantes :

$$\text{Formule (C)} : 1<R_1(650)/R_1(550)<1.2$$

$$\text{Formule (D)} : |R_2(650)/R_2(550)-R_1(650)/R_1(550)|<0.010$$

(où $R_1(650)$ représente la valeur de retard dans un plan de film à une longueur d'onde de 650 nm, et $R_2(650)$ représente la valeur de retard dans un plan de film à une longueur d'onde de 650 nm après avoir laissé le film reposer à une température 90°C pendant 48 heures).

3. Procédé selon la revendication 1 ou 2, dans lequel le film de retard est obtenu en formant un polymère contenant (a) une unité structurelle présentant une anisotropie d'indice de réfraction positive avec la fin d'absorption étant inférieure à 260 nm et (b) une unité structurelle présentant une anisotropie d'indice de réfraction négative avec la fin d'absorption étant de 260 à 380 nm.

4. Procédé selon la revendication 3, dans lequel ledit polymère est une résine de polycarbonate et/ou une résine de polyester carbonate.

5. Procédé selon la revendication 4, dans lequel :

ledit polymère est une résine de polycarbonate,
ladite unité structurelle (b) est une unité structurelle dérivée d'un composé dihydroxy représenté par la formule (1) suivante, et
ladite unité structurelle (a) est une unité structurelle dérivée d'un composé dihydroxy représenté par la formule (2) suivante et des unités structurelles dérivées d'un ou plusieurs composés dihydroxy choisis dans le groupe constitué d'un composé dihydroxy représenté par la formule (3) suivante, d'un composé dihydroxy représenté par la formule (4) suivante, d'un composé dihydroxy représenté par la formule (5) suivante et d'un composé dihydroxy représenté par la formule (6) suivante :

[Chem. 1]

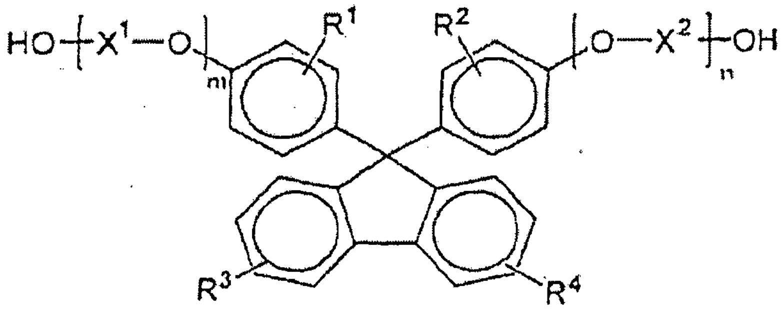

(1)

(où chacun de $R^1$ à $R^4$ représente indépendamment un atome d'hydrogène, un groupe alkyle substitué ou non substitué ayant de 1 à 20 atomes de carbone, un groupe cycloalkyle substitué ou non substitué ayant de 6 à 20 atomes de carbone, ou un groupe aryle substitué ou non substitué ayant de 6 à 20 atomes de carbone, et les groupes identiques ou différents sont substitués comme substituants respectifs sur quatre noyaux benzène ; chacun de $X^1$ et $X^2$ représente indépendamment un groupe alkylène substitué ou non substitué ayant de 2 à 10 atomes de carbone, un groupe cycloalkylène substitué ou non substitué ayant de 6 à 20 atomes de carbone, ou un groupe arylène substitué ou non substitué ayant de 6 à 20 atomes de carbone ; et chacun de m et n représente indépendamment un nombre entier de 0 à 5) ;

[Chem. 2]

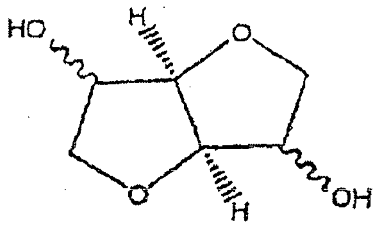

(2)

$HO-R^5-OH$ (3)

(où $R^5$ représente un groupe cycloalkylène substitué ou non substitué ayant de 4 à 20 atomes de carbone) ;

$HO-CH_2-R^6-CH_2-OH$ (4)

(où $R^6$ représente un groupe cycloalkylène substitué ou non substitué ayant de 4 à 20 atomes de carbone) ;

$H-(O-R^7)p-OH$ (5)

(où $R^7$ représente un groupe alkylène substitué ou non substitué ayant de 2 à 10 atomes de carbone, et p représente un nombre entier de 2 à 50) ; et

$HO-R^8-OH$ (6)

(où $R^8$ représente un groupe alkylène substitué ou non substitué ayant de 2 à 20 atomes de carbone, ou un groupe représenté par la formule (6A) suivante) :

[Chem. 3]

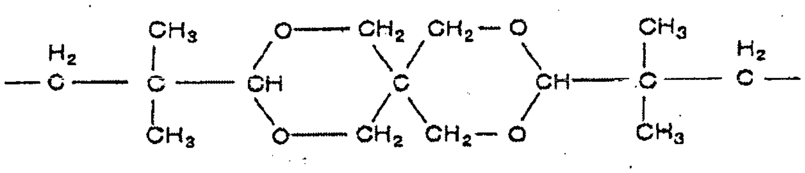 (6A)

6. Procédé selon la revendication 5, dans lequel dans ledit polymère, la teneur de l'unité structurelle dérivée d'un composé dihydroxy ayant une structure acétal est de 10 % en mole ou inférieure rapportée à toutes les unités structurelles dérivées d'un composé dihydroxy.

7. Procédé selon la revendication 5 ou 6, dans lequel :

ladite unité structurelle (b) est une unité structurelle dérivée dudit composé dihydroxy représenté par la formule (1), et
ladite unité structurelle (a) est une unité structurelle dérivée dudit composé dihydroxy représenté par la formule (2) et une unité structurelle dérivée dudit composé dihydroxy représenté par la formule (5).

8. Film de retard satisfaisant les relations des formules (A) et (B) suivantes :

$$\text{Formule (A) : } 0.7<R_1(450)/R_1(550)<1$$

$$\text{Formule (B) : } |R_2(450)/R_2(550)-R_1(450)/R_1(550)|< 0.020$$

(où $R_1(450)$ et $R_1(550)$ représentent la valeur de retard dans un plan de film aux longueurs d'ondes respectives de 450 nm et 550 nm, et $R_2(450)$ et $R_2(550)$ représentent la valeur de retard dans un plan de film aux longueurs d'ondes respectives de 450 nm et 550 nm après avoir laissé le film reposer à une température de 90°C pendant 48 heures) et satisfaisant de plus les relations des formules (C) et (D) suivantes :

$$\text{Formule (C) : } 1<R_1(650)/R_1(550)<1.2$$

$$\text{Formule (D) : } |R_2(650)/R_2(550)-R_1(650)/R_1(550)|<0.010$$

(où $R_1(650)$ représente la valeur de retard dans un plan de film à une longueur d'onde de 650 nm, et $R_2(650)$ représente la valeur de retard dans un plan de film à une longueur d'onde de 650 nm après avoir laissé le film reposer à une température de 90°C pendant 48 heures), lequel est un film de retard obtenu en formant un polymère contenant (a) une unité structurelle présentant une anisotropie d'indice de réfraction positive avec la fin d'absorption étant inférieure à 260 nm et (b) une unité structurelle présentant une anisotropie d'indice de réfraction négative avec la fin d'absorption étant de 260 à 380 nm, dans lequel :

ledit polymère est une résine de polycarbonate,
ladite unité structurelle (b) est une unité structurelle dérivée d'un composé dihydroxy représenté par la formule (1) suivante, et
ladite unité structurelle (a) est une unité structurelle dérivée d'un composé dihydroxy représenté par la formule (2) suivante et des unités structurelles dérivées d'un ou plusieurs composés dihydroxy choisis dans le groupe constitué d'un composé dihydroxy représenté par la formule (3) suivante, d'un composé dihydroxy représenté par la formule (4) suivante, d'un composé dihydroxy représenté par la formule (5) suivante et d'un composé dihydroxy représenté par la formule (6) suivante :

[Chem. 1]

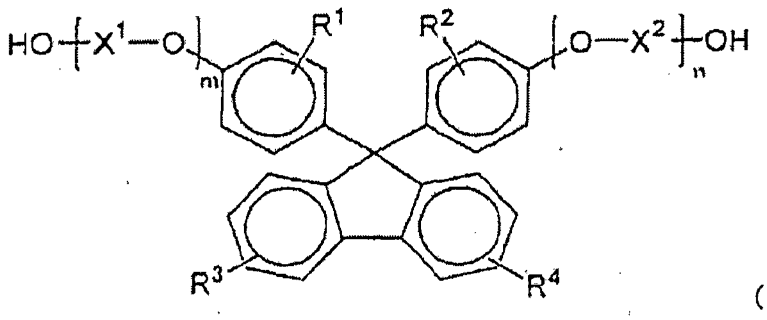

(1)

(où chacun de $R^1$ à $R^4$ représente indépendamment un atome d'hydrogène, un groupe alkyle substitué ou non substitué ayant de 1 à 20 atomes de carbone, un groupe cycloalkyle substitué ou non substitué ayant de 6 à 20 atomes de carbone, ou un groupe aryle substitué ou non substitué ayant de 6 à 20 atomes de carbone, et les groupes identiques ou différents sont substitués comme substituants respectifs sur quatre noyaux benzène ; chacun de $X^1$ et $X^2$ représente indépendamment un groupe alkylène substitué ou non substitué ayant de 2 à 10 atomes de carbone, un groupe cycloalkylène substitué ou non substitué ayant de 6 à 20 atomes de carbone, ou un groupe arylène substitué ou non substitué ayant de 6 à 20 atomes de carbone ; et chacun de m et n représente indépendamment un nombre entier de 0 à 5) ;

[Chem. 2]

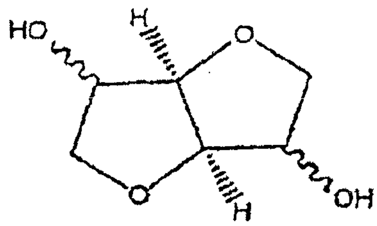

(2)

$HO-R^5-OH$ (3)

(où $R^5$ représente un groupe cycloalkylène substitué ou non substitué ayant de 4 à 20 atomes de carbone) ;

$HO-CH_2-R^6-CH_2-OH$ (4)

(où $R^6$ représente un groupe cycloalkylène substitué ou non substitué ayant de 4 à 20 atomes de carbone) ;

$H-(O-R^7)_p-OH$ (5)

(où $R^7$ représente un groupe alkylène substitué ou non substitué ayant de 2 à 10 atomes de carbone, et p représente un nombre entier de 2 à 50) ; et

$HO-R^8-OH$ (6)

(où $R^8$ représente un groupe alkylène substitué ou non substitué ayant de 2 à 20 atomes de carbone, ou un groupe représenté par la formule (6A) suivante) :

[Chem. 3]

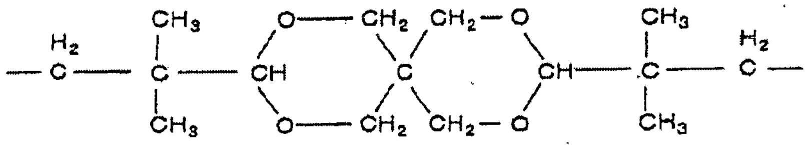

(6A)

9. Film de retard selon la revendication 8, dans lequel dans ledit polymère, la teneur de l'unité structurelle dérivée d'un composé dihydroxy présentant une structure acétal est de 10 % en mole ou inférieure rapportée à toutes les unités structurelles dérivées d'un composé dihydroxy.

10. Film de retard selon la revendication 8 ou 9, dans lequel :

ladite unité structurelle (b) est une unité structurelle dérivée dudit composé dihydroxy représenté par la formule (1), et
ladite unité structurelle (a) est une unité structurelle dérivée dudit composé dihydroxy représenté par la formule (2) et une unité structurelle dérivée dudit composé dihydroxy représenté par la formule (5).

11. Film de retard selon l'une quelconque des revendications 8 à 10, lequel est un film monocouche.

12. Film de retard selon l'une quelconque des revendications 8 à 11, dans lequel le coefficient photo-élastique du polymère est de $45\times10^{-12}$ $Pa^{-1}$ ou inférieur.

13. Film de retard selon l'une quelconque des revendications 8 à 12, dans lequel la température de transition vitreuse est de 110 à 150°C.

14. Plaque de polarisation circulaire fabriquée en empilant le film de retard selon l'une quelconque des revendications 8 à 13 et une plaque de polarisation.

15. Dispositif d'affichage d'image présentant la plaque de polarisation circulaire selon la revendication 14.

16. Dispositif d'affichage d'image selon la revendication 15, dans lequel ledit dispositif d'affichage d'image utilise un EL organique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3325560 B
- WO 200641190 A
- WO 201064721 A
- US 2941956 A
- JP 47033279 B


### Non-patent literature cited in the description


- *J. Org. Chem.,* 1963, vol. 28, 2069-2075
- *Chemical Review,* 1981, vol. 8 (4), 619-621
- *Journal of the Society of Rheology Japan,* 1991, vol. 19, 93-97